(19) Europäisches Patentamt
European Patent Office
Office européen des brevets

(11) **EP 1 910 898 B1**

(12) **EUROPEAN PATENT SPECIFICATION**

(45) Date of publication and mention
of the grant of the patent:
**10.10.2012 Bulletin 2012/41**

(51) Int Cl.:
***G03F 7/20*** (2006.01)

(21) Application number: **06828786.1**

(86) International application number:
**PCT/EP2006/005685**

(22) Date of filing: **13.06.2006**

(87) International publication number:
**WO 2007/033710 (29.03.2007 Gazette 2007/13)**

(54) **LITHOGRAPHIC APPARATUS AND METHOD FOR DETERMINING A POLARIZATION PROPERTY OF A LITHOGRAPHIC APPARATUS**

LITHOGRAFISCHE VORRICHTUNG UND VERFAHREN ZUR BESTIMMUNG EINER POLARISATIONSEIGENSCHAFT EINER LITHOGRAFISCHEN VORRICHTUNG

APPAREIL DE LITHOGRAPHIE ET PROCEDE POUR LA DETERMINATION D'UNE CARACTERISTIQUE DE POLARISATION D'UN APPAREIL DE LITHOGRAPHIE

(84) Designated Contracting States:
**DE FR GB IT NL**

(30) Priority: **13.06.2005 US 689800 P**
**24.02.2006 US 361049**

(43) Date of publication of application:
**16.04.2008 Bulletin 2008/16**

(73) Proprietor: **ASML Netherlands B.V.**
**5504 DR Veldhoven (NL)**

(72) Inventors:
• **VAN DE KERKHOF, Marcus, Adrianus**
**NL-5708 GT Helmond (NL)**
• **DE BOEIJ, Wilhelmus, Petrus**
**NL-5508 TL Veldhoven (NL)**
• **VAN GREEVENBROEK, Hendikus, Robertus, Marie**
**NL-5644 NP Eindhoven (NL)**
• **KLAASSEN, Michel, Fransois, Hubert**
**NL-5641 CA Eindhoven (NL)**
• **KOK, Haico, Victor**
**NL-5653 RD Eindhoven (NL)**
• **WEHRENS, Martijn, Gerard, Dominique**
**NL-5581 AD Waalre (NL)**
• **UITTERDIJK, Tammo**
**NL-3732 GJ De Bilt (NL)**

• **ROOIJAKKERS, Wilhelmus, Jacobus, Maria**
**NL-5581 Waalre (NL)**
• **KUIPER, Johannes, Maria**
**NL-1541 TZ Koog aan de Zaan (NL)**
• **VAN DOOREN, Leon**
**NL-2625 VL Delft (NL)**
• **SONNEVELD, Jacob**
**NL-5685 EJ Best (NL)**
• **GILING, Erwin, Johannes, Martinus**
**NL-2625 AS Delft (NL)**

(74) Representative: **Maas, Abraham Johannes et al**
**ASML Netherlands B.V.**
**Corporate Intellectual Property**
**P.O. Box 324**
**5500 AH Veldhoven (NL)**

(56) References cited:
**JP-A- 61 190 935       US-A1- 2004 114 150**
**US-A1- 2005 099 613**

• **G MCINTYRE, A NEUREUTHER: "PSM Polarimetry: Monitoring Polarization at 193 nm Hihg-NA and Immersion with Phase Shifting Masks" PROCEEDINGS OF SPIE, vol. 5754, May 2004 (2004-05), pages 80-91, XP002406246 Bellingham**

**EP 1 910 898 B1**

**Description**

RELATED APPLICATIONS

FIELD

The present invention relates to a lithographic apparatus and a method for determining a polarization property.

BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a pattern of radiation corresponding to a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

A known wafer scanner (EP 1037117) comprises an illuminator and a projection lens. In operation a reticle with a circuit pattern in its cross section is positioned between illuminator and projection lens. A wafer is positioned such that an image of the circuit pattern on the reticle is formed on the surface of the wafer by radiation that passes through the illuminator, the reticle and the projection lens respectively.

The demand for ever-smaller features to be imaged with lithographic apparati such as steppers and scanners has resulted in the use of projection systems with increasing numerical aperture (NA). The angle of rays of radiation within the projection apparatus with respect to the optical axis increases with increasing NA. The vector nature of light becomes important for imaging because only identically polarized components of electromagnetic waves interfere. Therefore it is not the wavefront quality alone that determines the image contrast; but also the polarization has a considerable influence on image contrast.

Due to production limitations, the imaging properties of the projection lens differ for different polarization status of the light. The imaging performance of wafer scanners with a projection lens operated with high numerical apertures (NA) depend significantly on the polarization state of the light coming out of an illuminator (in combination with the polarization dependent imaging properties of the projection lens). One effect is that where an image (formed at the wafer) of a circuit pattern on a reticle can be in focus at a distance z1 between projection lens and wafer for a first polarization state, the image is in focus at a distance z2 between projection lens and wafer for a second polarization state. While positioning the wafer at z1 to have the image of the circuit pattern for radiation with the first polarization state in focus on the wafer, the part of the image formed by the light having the second polarization state is out of focus and leads to wider lines. By improving control of polarization, the line edge roughness and CD control for small features can be improved.

The current trend of increasing the NA value of the projection lens leads to increased loss of image quality at wafer level because of polarization states of lower quality.

Furthermore, the use of illumination radiation having specifically desired states of polarization for specific regions is increasingly being used for imaging features aligned in particular directions. Consequently, it is desirable to know the state of polarization of the radiation impinging on the patterning device, such as a reticle. It can also be desirable to know the effect on the state of polarization caused by the projection system (e.g., projection lens). Existing radiation sensors built into lithographic apparatus are typically polarization insensitive. Furthermore it is thought that the state of polarization of the illumination radiation at the level of the patterning device cannot be easily or cost-effectively measured at the level of the substrate without knowing the effect of the projection system on the polarization.

The polarization of the radiation when impinging on the wafer is for a part determined by the polarization of the radiation after passing the illuminator. In order to perform polarization measurements of the radiation at the illuminator, a polarization analyzer must be introduced between the illuminator and the projection lens.

With the increasing quality level of polarization control, it is desired to know the polarization at different positions in a plane perpendicular to the optical axis of the illuminator. Measurements capable of giving position dependent information are called field resolved measurements.

When field resolved polarization measurements are needed, the polarization analyzer, which is needed for every polarization measurement, must comprise a polarizing element and a motor to move that polarizing element to the field positions to be analyzed. Alternatively, it must comprise a number of polarizing elements at the different field positions to be analyzed and an equal amount of shutters to select one polarizing element. By opening the shutter at a desired field position and closing the shutters at the other positions, the polarization can be measured for that position. A motor or a combination of several polarizing elements and several shutters necessarily comprise a lot of space between the illuminator and the projection lens.

In known lithographic apparatus the space between the illuminator and the projection lens is rather small and is occupied by the reticle stage compartment. This reticle stage compartment is the area in which the reticle stage moves. Other components may not intrude that area because of collision risks between those other components and the reticle stage.

Equally, when the polarization state of the projection beam has to be measured after the radiation has passed the projection lens, the wafer stage consumes the space needed by the polarization analyzer.

As a consequence there is no space left in such a lithographic apparatus to insert a polarization analyzer for providing field resolved measurements of the projection beam of radiation.

SUMMARY

In one embodiment, the radiation received from an illuminator has a predefined and known polarization state.

In one embodiment, the polarization sensor globally consists of two parts: some optical elements that treat the polarization of the illuminator light (retarder, polarizer), and a detector that measures the intensity of the treated light. From the intensity measurements, the Stokes vector can be derived consisting of four parameters $S_0$ to $S_3$. A field point is a position in a cross section perpendicular to the optical axis of the beam of radiation passing through the illuminator. Light at each field point can be measured using a field stop at that point through which a narrow beam of light travels. The light emerging from the field stop is detected by a detector, for example, a 2-d detector. The intensity detected by a 2-d detector comprises an array of sub-intensity measurements each collected at an individual x-y position, where the x,y position corresponds to a pupil coordinate in the illuminator. Three or more intensity measurements per field point are sufficient to define the polarization state of the light at that field point. From the three or more intensity measurements collected at each x-y point on the detector, a polarization pupil map can be constructed; which comprises a Stokes vector at each measured pupil position in the illuminator from which light travels through the field stop. Measured information on the polarization at a field point can be used to fine-tune polarization setting of the illuminator. In addition, the polarization state can be measured at different times to monitor the illuminator output over time. Additionally, measurements can be taken at a series of field points and these measurements used to map the polarization state of radiation as a function of field point position.

The contribution of the projection lens concerning polarization can be measured using additional optics. The polarization state of the light at wafer level can be monitored over time as well, taking account of for example drift effects of illuminator and/or lens.

Thus, in configurations of the invention discussed below, both illuminator and projection lens polarization sensors may include optical elements that treat and analyze a polarization state of light, as well as detectors to measure intensity of light.

In addition to having knowledge of the state of polarization of illumination radiation, it may also be desirable to have information regarding the effect on the state of polarization of illumination radiation caused by the projection system. US 2004/0114150 discloses an apparatus for measuring the polarizing effect of a projection system using a polarizer at reticle level and a polarization sensitive detection at mask level.

According to one aspect of the invention there is provided a lithographic apparatus, as defined in the appended claims.

According to a further aspect of the invention there is provided a method for determining a polarization property of a lithographic apparatus, as defined in the appended claims.

Embodiment of the invention will now be described, by way of example only, with reference to the accompanying schematic drawings in which corresponding reference symbols indicate corresponding parts, and in which:

Figure 1 illustrates polarized light from the illuminator entering a polarization sensor module under angles corresponding to the numerical aperture (NA);

Figure 2 illustrates a camera positioned at wafer level in a polarization sensor system, according to a configuration of the invention;

Figure 3 is a chart that discloses the relation between features associated with a polarization sensor;

Fig. 4 is a drawing of an active reticle tool ;

Figure 5(a) depicts a portion of a polarization sensor ;

Figure 5(b) illustrates a spring loaded retarder which can be used with the present invention;

Figure 6 depicts a portion of another polarization sensor ;

Figure 7 depicts a portion of another polarization sensor ;

Figure 8(a) depicts a portion of another polarization sensor ;

Figure 8(b) illustrates a passive reticle system ;

Figure 8(c) illustrates details of a polarization sensor module;

Figures 9a-c depict schematic diagrams of three different polarization sensors ;

Figure 9(d) illustrates details of a multipass system having a beam splitting polarizer provided below a pinhole at a reticle;

Figure 10 depicts interaction of an unpolarized light wave with a surface;

Figure 11 depicts a lithographic apparatus ;

Figure 12 shows schematically the lithographic apparatus according to another embodiment of the invention;

Figure 13 shows schematically the lithographic apparatus according to a modification of the embodiment illustrated in Figure 12;

Figure 14 shows schematically the lithographic apparatus according to a further example; and

Figure 15 schematically illustrates an arrangement for collimating the radiation in the region of the polarization-active components.

DETAILED DESCRIPTION

In one embodiment, the polarization state be well defined and known during wafer exposure, so that the image quality at wafer level can be improved, resulting in small line widths, especially with projection lenses with high NA values. To measure and monitor the exact polarization state of the light used for wafer exposures, polarization measurements have to be performed in the wafer scanner. To quantify and monitor the illuminator in terms of polarization, the sensor can be positioned at reticle level. If, in addition, the polarization behavior of the projection lens needs to be monitored or quantified, additional optics could be implemented at wafer level.

In the invention, the polarization sensor can be viewed as having two parts. The first part comprises an optical element that treats the polarization of the illuminator light (for instance a retarder or a polarizing beam splitter) and is here called the polarization sensor module. The second part comprises a detector. The detector is used to measure the intensity of the treated light. The polarization sensor module can comprise a group of parts that are physically housed together. The detector can be located at a relatively large distance from the polarization sensor module. However, in some configurations not forming part of the invention, the detector can be housed or located in close proximity to components comprising the polarization sensor module.

In order to get a polarization map of the illuminator pupil, a number of field points are defined over the pupil. At each field point, a minimum of three different configuration of the polarization sensor module are used to measure the polarization. Three different measurements can define the polarization state if one is not concerned with an unpolarized state. Taking into account an unpolarized state, measurements taken at four different configurations of the polarization sensor module are needed. Here each configuration has a different retardation property and belongs to a specific input polarization state. In general, the detector measures different intensities for all configurations used to measure each field point. When comparing the intensity measurements for each field point, the original polarization state of the light at that particular field point can be found, using calculations based on the Stokes vectors. This can be performed for all field points, resulting in a polarization map of the pupil. The reason for using Stokes instead of Jones is that the Stokes vectors include unpolarized light, and the Jones vectors do not.

The Stokes parameters can be derived from the measured intensities of the polarization spots, at a certain combination between the input illumination polarization mode and the optical configuration of the polarization sensor module. The Stokes vector consists of four parameters $S_0$ to $S_3$, see equation 1. SOP means State Of Polarization.

$$\bar{S} = \begin{bmatrix} S_0 \\ S_1 \\ S_2 \\ S_3 \end{bmatrix} = \begin{bmatrix} S_0 = Total\ Power\ \text{(in polarised and unpolarised states)} \\ S_1 = Power\ difference\ between\ Linear\ Vertical\ SOP\ \&\ Horizontal\ SOP \\ S_2 = Power\ difference\ between\ Linear + 45^{\circ}\ SOP\ \&\ Linear - 45^{\circ}\ SOP \\ S_3 = Power\ difference\ between\ Right\ Hand\ Circular\ (RHC)\ \&\ Left\ HC\ SOP \end{bmatrix} \quad \textbf{equation 1}$$

The Stokes parameters may be calculated by measuring intensities transmitted at combinations of for example horizontal, vertical, 45° and left- and right-circular polarizers. To resolve all 4 components of the Stokes vector, four measurements can be used per field point. The Stokes vectors can be converted into Jones vectors using the respective E-fields formulas, where $\Delta\varphi = \varphi_y - \varphi_x$ represents the difference in phase between the ordinary and extraordinary states, see equation 2.

$$\vec{E} = \begin{pmatrix} E_x e^{i\phi_x} \\ E_y e^{i\phi_y} \end{pmatrix} \Rightarrow \begin{bmatrix} S_0 \\ S_1 \\ S_2 \\ S_3 \end{bmatrix} = \begin{bmatrix} E_x^2 + E_y^2 \\ E_x^2 - E_y^2 \\ 2E_x E_y \cos\Delta\phi \\ 2E_x E_y \sin\Delta\phi \end{bmatrix} \qquad \text{equation 2}$$

For ease of visualization, polarization states are often specified in terms of the polarization ellipse, specifically its orientation and elongation. A common parameterization uses the azimuth (or "rotation") angle $\alpha$ which is the angle between the major semi-axis of the ellipse and the x-axis, and the ellipticity angle e where tan(e) is the ratio of the two semi-axes. An ellipticity of $\tan(\varepsilon)$ = +/- 1 corresponds to fully circular polarization. The relation between this representation and the Stokes parameters is equation 3.

$$\alpha = \tan^{-1}\left(\frac{S_2}{S_1}\right), \qquad \varepsilon = \frac{1}{2}\sin^{-1}\left(\frac{S_3}{\sqrt{S_1^2 + S_2^2 + S_3^2}}\right) \qquad \text{equation 3}$$

An optical component that changes the incident polarization state from an incoming Stokes vector $S_{in}$ to some output state $S_{out}$ (through reflection, transmission or scattering) can be described by a 4x4 Mueller matrix $M$. This transformation is given by equation 4 where $M_{tot}$ can be a product of $n$ cascaded components $M_i$.

$$S_{out} = \begin{bmatrix} S_{out,0} \\ S_{out,1} \\ S_{out,2} \\ S_{out,3} \end{bmatrix} = M_{tot}\, S_{in} = \begin{bmatrix} m_{00} & m_{01} & m_{02} & m_{03} \\ m_{10} & m_{11} & m_{02} & m_{03} \\ m_{20} & m_{21} & m_{02} & m_{03} \\ m_{30} & m_{31} & m_{02} & m_{03} \end{bmatrix} \begin{bmatrix} S_{in,0} \\ S_{in,1} \\ S_{in,2} \\ S_{in,3} \end{bmatrix} \qquad \text{equation 4}$$

For example, for a system consisting of a rotating retarder and a polarizer, after multiplication of the individual Mueller matrices the output Stokes vector can be computed using equation 5. Here $M_{pol}$ and $M_{ret}$ are the Mueller matrices of respectively the polarizer and retarder. $R(a)$ is a rotation matrix which is a function of rotation angle $\alpha$, and represents the rotation of the retarder.

$$S_{out} = M_{tot}\, S_{in} = M_{pol}\, R(\alpha)\, M_{ret}\, R(-\alpha)\, S_{in} \qquad \text{equation 5}$$

As was earlier mentioned, at least three measurements are used to solve the 4 parameters of the unknown $S_{in}$ vector. As mentioned above, although there are four Stokes parameters, there is some redundancy between them, so that three measurements can suffice to determine them at least normalized with respect to the overall intensity of the radiation. In one embodiment, four measurements are used to solve the four parameters of the unknown S*in* vector. By changing the contents of the Mueller matrix $M_{tot}$ 4 times in a well-defined way, each belonging to a different set of optical components, 4 equations are obtained, from which the system of 4 unknown parameters is be solved. It will be clear to a person skilled in the art, that more measurements can be used as well to solve the 4 unknown parameters.

It will be appreciated that if less than three measurements are used, the measurements can still be used to characterize the polarization state of the illuminator or the projection lens. For instance, if one measurement is done, i.e. a measurement for a fixed polarization state, and that measurement is repeated over time, for instance between two batches of wafers in a wafer fab, changes to the polarization state of the wafer scanner can be detected. When this change passes a certain threshold, this can trigger a calibration or maintenance of the wafer scanner.

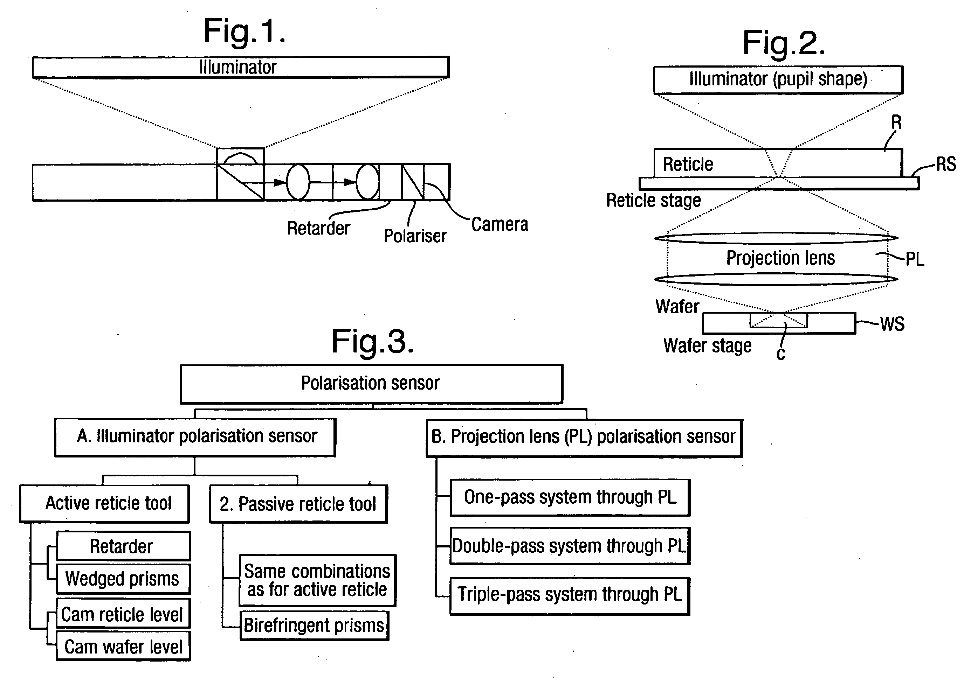

Polarized light from the illuminator enters the polarization sensor module under angles corresponding to the numerical aperture (NA). This is shown in figure 1. The polarized light passes respectively through a first collimating lens, a mirror and a positive lens, together forming beam shaping and collimating optics. The collimating lens is arranged to give parallel beams onto the mirror. The mirror is arranged to reflect the light in a desired direction. The desired direction is perpendicular to the optical axis of the projection system. With a perpendicular direction and parallel beams the polarization sensor module has a relatively low height (values along the optical axis of the projection system along with the sensor extends mechanically). Then the light passes through a positive lens, a field stop and a lens to collimate the light again. The field stop is used to select a particular field point.

After passing the beam shaping and collimating optics, the light enters a polarization state analyzer. To change the polarization state of the incoming light in a defined way, a set of optics is used that will influence the retardation of the light, i.e. Tm and Te waves are shifted with respect to each other resulting in a netto phase difference. Then a polarizer selects one polarization. In the second part of the polarization sensor the intensity of the desired polarization mode is detected with a camera.

Other positions of the field stop are possible as well as will be obvious to the skilled person.

Figure 3 is a chart that discloses the relation between features associated with polarization sensors.

One distinction is between polarization sensor modules configured on the one hand to quantify the polarization of light emerging from the illuminator (*A. illuminator polarization sensor*) and polarization sensors configured on the other hand to monitor/quantify the polarization of light traveling through the projection lens (*B. projection, lens polarization sensor*).

In an embodiment of the invention, a reticle tool comprises a carrier and the polarization sensor module. The polarization sensor may comprise additional parts at wafer level (see figure 2). "At wafer level" means the level where, during normal operation, a wafer is positioned. "At reticle level" means a position located between the illuminator and the projection lens of the lithographic apparatus At "reticle level" a reticle is present during normal operation of the wafer scanner when illuminating the wafer.

The wafer scanner comprises a reticle stage RS to support and position a reticle R. In one embodiment of the invention, the reticle tool is configured to replace a reticle on the reticle stage; in other words the mechanical interface between the reticle stage and a reticle is the same as the mechanical interface between the reticle stage and the reticle tool. This make the reticle tool loadable in the manner of a production reticle. Thus, the reticle tool is compatible with already existing wafer scanners; it is wafer scanner independent. Also, a qualification and calibration procedure of the reticle tool can be performed outside the wafer scanner. The reticle tool can comprise one or more polarization sensor modules. The carrier of the reticle tool comprises a layer of known reticle material as used for production reticles that comprise circuit patterns during operation of a wafer scanner. Known reticle material is highly stable under temperature differences, so that the position of the modules will be stable. Additionally, the reticle tool can comprise marks configured to measure the position of the sensor modules and any deformations of the reticle tool. Such a measurement can be performed with a sensor as known from EP 1267212.

Aspects of the apparatus that employs the illuminator polarization sensor module (A) are divided into active reticle configurations (1) and passive reticle configurations (2). "Active" means that some parts of the polarization sensor module can be moved and/or rotated during polarization measurements, and "passive" means that all parts are fixed onto the carrier.

As illustrated in Figure 3, both an active reticle tool and a passive reticle tool can comprise a retarder or wedged prisms (indicated in Figure 3 by "same combinations as for active reticle"). Alternatively, a passive reticle tool may comprise birefringent prisms.

In configurations of the invention in which a camera (or other polarization detector) is positioned at wafer level WS (see Figure 2), for example, for an active reticle tool (Figure 3), the reticle tool does not need any interfaces for power, control signals (such as a trigger to start measuring) and measurement results. Alternatively and not forming part of the invention, a camera may be placed at reticle level for an active reticle tool.

In addition, Figure 3 lists different types of projection lens polarization sensors (B) . The three general configurations listed are based on whether a light beam passes through the projection lens (PL) once, twice or three times. For the projection lens polarization modules, besides components positioned at the reticle level, some additional optics are located at wafer level.

A. Illuminator polarization sensor

In embodiments described below, active and passive reticle tools are disclosed, wherein a reticle tool comprises a collimation lens and a folding mirror. By collimating the light received from an illuminator and reflecting it in a direction perpendicular to the optical axis of the illuminator, the reticle tools have a relatively low overall height, so that the tools have the same mechanical interface with the reticle stage. This permits an active or passive reticle tool to be simply substituted for a production reticle on a reticle stage without having to reconfigure the reticle stage.

1. Active Reticle Tool

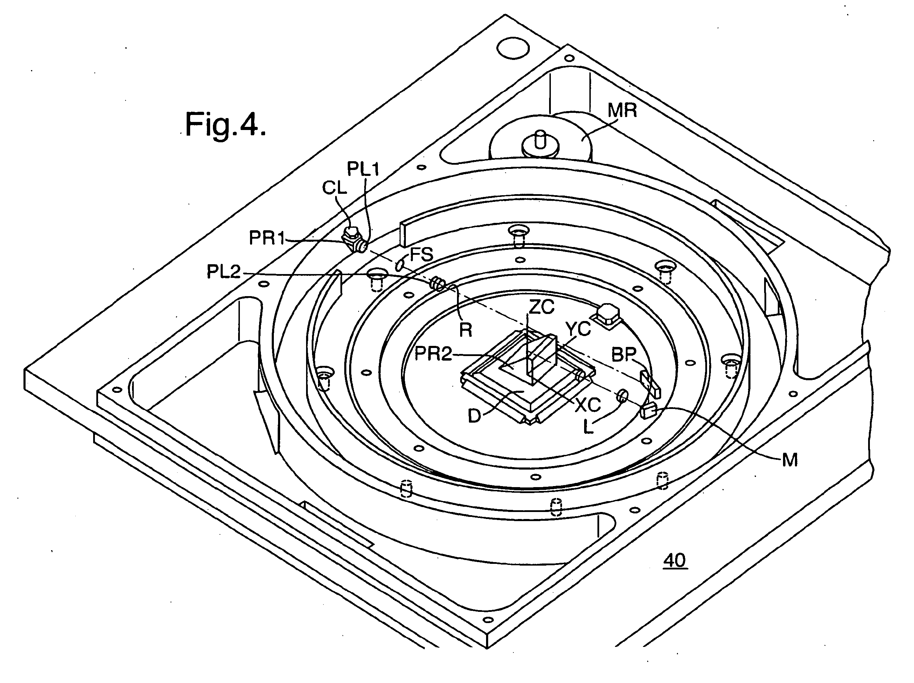

In one example, an active reticle tool 40 (see figure 4) contains one optical channel with an active rotating retarder. Light emerging from the illuminator is incident at collimating lens CL and is reflected at a 90 degree angle by prism PR1, emerges through positive lens PL1 and passes through field stop (pinhole) FS. Light then passes through positive lens PL2 and rotating retarder R, which can be configured as a quarter wave plate, for example. Brewster plate (or "Brewster element") BP is used as a polarizer, wherein the angle of BP is arranged at a Brewster angle to reflect light of one polarization state while passing light of another polarization state. The Brewster plate BP can be configured to reflect from the surface of the plate, or can be configured as a prism that reflects polarized light at an internal surface of the prism. Light reflected from the surface of BP is reflected off a mirror M and passes through lenses L1 and L2 before entering prism PR2, in which the light is directed downwards to detector D. IN one configuration, detector D is a CCD chip. Reticle tool 40 is also provided with drive motor MR which can rotate the optical system. In other configurations, other types of motors are possible.

Preferably, the active reticle tool is configured to couple to a reticle stage of a lithographic apparatus wherein the active reticle tool can be exchanged for a reticle used to pattern substrates. In addition, the complete optical system of the reticle tool is preferably configured to rotate around the z-axis relative to the carrier of the reticle tool. By rotating the optical system of the reticle tool, the first collimation lens will change both x and y position. This is used to be able to measure several field points and to assemble a polarization pupil map. In a wafer scanner, the reticle tool is positioned on a reticle stage that is arranged to be movable in y direction. The movement in y direction of the reticle stage supporting the reticle tool facilitates measurements at even more positions. This implies an active rotation of the field point on the reticle to cover the field in x (for example by two DC motors), and the present reticle-y-movement to position the channel in y direction. In addition, dedicated data acquisition electronics, power and communication are provided to enable the two active rotations.

The camera (for instance, a CCD chip) can be positioned on the reticle-shaped tool, or a camera at wafer level can be used.

In this embodiment, the reticle tool 40 comprises a first collimation lens CL and a folding mirror M. By collimating the light and reflecting it in a direction perpendicular to the optical axis of the illuminator, the reticle tool has a relatively low overall height, so that it has the same mechanical interface with the reticle stage, i.e. the reticle tool can be positioned on the reticle stage arranged to support production reticles without changes.

The data acquisition of this embodiment will be relatively simple. Also, the image intensity does not need to be continuous, so that for instance parcellation will not influence the polarization state determination.

It will be clear to one of ordinary skill that using one optical channel for measurements of several polarization states reduces calibration requirements. Additionally, the calibration of the reticle tool can be performed outside the machine, using a defined light source.

Rotating Retarder

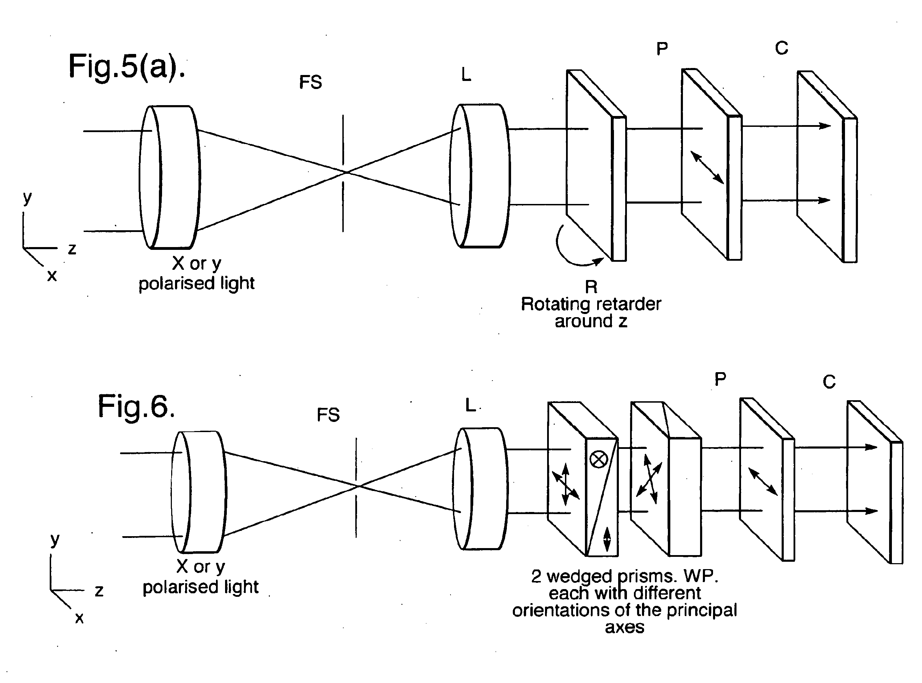

Figure 5(a) depicts a portion of a polarization sensor, including a rotating retarder R, which can be used with the invention. In the case of a rotating retarder (for example, a quarter-wave plate), around its axis over at least four angles, the retardation of all the incoming light is affected in the same amount (Fig. 5a). The rotation movement could be performed, for example, by a miniature worm-wheel construction.

In Figure 5(a), the detector is a camera C, but could be a photo cell or a photo multiplier. It will be appreciated that any detector arranged to detect intensity is usable.

However, other devices, e.g., a CCD-camera, can be used to measure the rotation of the retarder. The rotation angle of the retarder need not be exactly manipulated, because the rotation angle can be checked, for example, by placing a small radial marker onto the retarder, and imaging the marker onto the camera. From this image marker position, the exact rotation of the retarder can be derived and corrected for afterwards. By placing the small radial marker at a large radial distance from the rotation axis of the retarder, the resolution of the CCD-camera can be relatively low, and still permit an accurate determination of the rotational position of the retarder.

It will be appreciated that repeated measurements of a given rotation angle of the retarder and of the optical system of the reticle tool can be performed in order to average out angular positioning errors that might occur for a single measurement.

In one configuration, the detector is placed at wafer level. This means that after passing through the reticle tool, the light passes through the projection lens system before reaching the detector. The light passes the projection lens system at the same position (i.e. the same part of the cross section of the projection lens) the influence of the projection lens system will be equal. This is because the polarizer of the reticle tool has the same rotation relative to the projection lens system, so that the light when passing the projection lens system is constant.

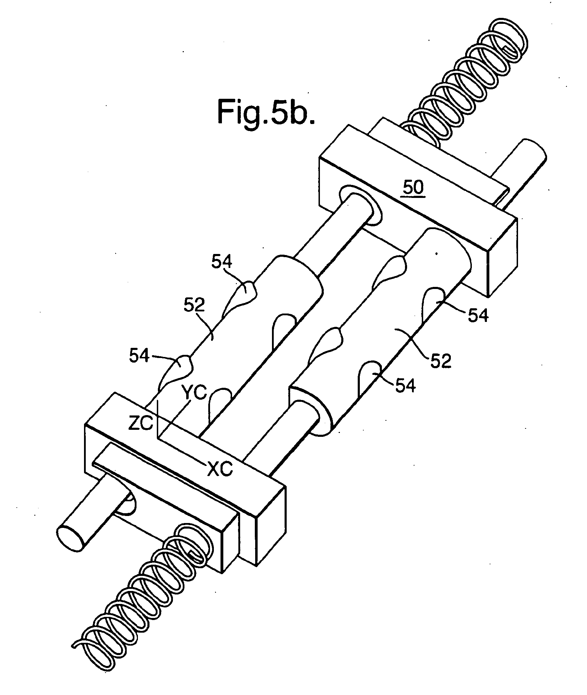

Figure 5(b) illustrates a spring loaded retarder 50 arranged according to a further configuration of the present invention. In this case, two separate cylinders 52 each are provided with two optical retarders 54. In the configuration shown, cylinders 52 can be relatively displaced with respect to each other to produce four possible combinations of retarders for light passing, for example, from left to right. This results in four possible degrees of rotation of light.

Wedged Prisms

In another non-inventive, configuration, instead of using the active rotating retarder as described above, two wedged prisms which are fixed onto the reticle (Fig. 6) can be used to induce retardation of the beam.

2. Passive reticle tool

Birefringent Prisms

In one embodiment using wedged prisms, four thin birefringent wedge prisms BR and a polarizer P are incorporated into an imaging polarizer (see Fig. 6), such that mesh-like multiple fringes are generated over a detector, such as a CCD image sensor of a video camera. The fringes result from the fact that light passing through the wedge prisms is rotated differently as a function of position. In other words, each wedge prism consists of a pair of wedges of material whose optical axis is mutually rotated between wedges, for example, a 90 degree rotation. Considering only one of the pair of wedges within a prism, it is clear that the physical thickness of the wedge varies as a function of position along a given direction, for example, along the y direction in the first wedge prism. Accordingly, the degree of optical retardation also varies along the y direction, wherein the polarization direction of light emitted from the wedge, varies as a function of y position. This results in a variation of the component of polarized light parallel to the polarizer direction as a function of y position, resulting in a variation of the intensity of light passed by the polarizer (only light parallel to the polarizer direction gets passed) as a function of y position. In order that the effect of changing rotation as a function of position not be cancelled by the second wedge, the optical direction of the crystal forming the second wedge is rotated at 90 degrees with respect to the first wedge, so that, although the physical thickness is constant along the Y- direction, the effective optical rotation still can vary. The Fourier analysis of the obtained fringes provides information for determining the two-dimensional distribution of the state of polarization. No mechanical or active elements for analyzing polarization are used, and all the parameters related to the spatially-dependent monochromatic Stokes parameters corresponding to azimuth and ellipticity angles can be determined from a single frame.

In the configuration illustrated in Figure 6, there are two wedge prisms arranged in series, comprising a set of four wedges in total wherein the fast axes of the four wedges are oriented at 0°, 90°, 45° and -45°. The wedge angles of both prisms are assumed to be small enough that the refraction occurring at the inclined contact surfaces is negligible. The resulting intensity pattern detected at a detector typically assumes a mesh shape of varying intensity in both x and y directions. The Fourier analysis of the intensity mesh allows a reconstruction of the 2-dimensional distribution of input polarization states of light received through a pinhole at a given field position. By proper choice of wedge angle, which determines how rapidly the polarization retardation of emitted light changes with x or y position, as well as camera resolution, the measurement resolution of the two-dimensional polarization state distribution can be optimized.

In one embodiment, the detector is placed at wafer level. This means that after passing through the reticle tool, the light will pass through the projection lens system before reaching the detector. The light passes through the projection lens system at the same position (i.e. the same part of the cross section of the projection lens) the influence of the projection lens system will be equal. This is because the polarized of the reticle tool has the same rotation relative to the projection lens system, so that the light when passing the projection lens system is constant.

It will be appreciated that repeated measurements of a given rotation angle of the retarder and of the optical system of the reticle tool can be performed in order to average out angular positioning errors that might occur for a single measurement.

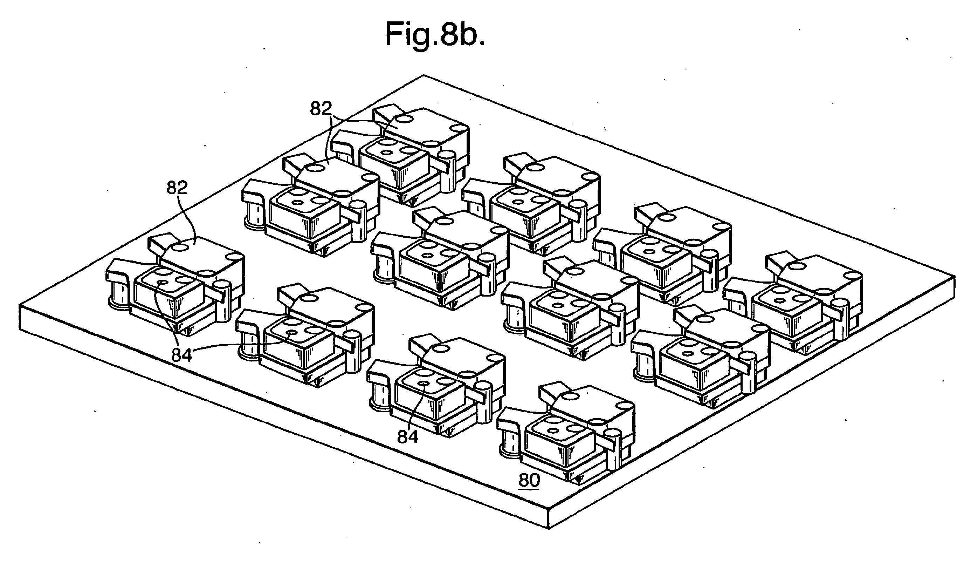

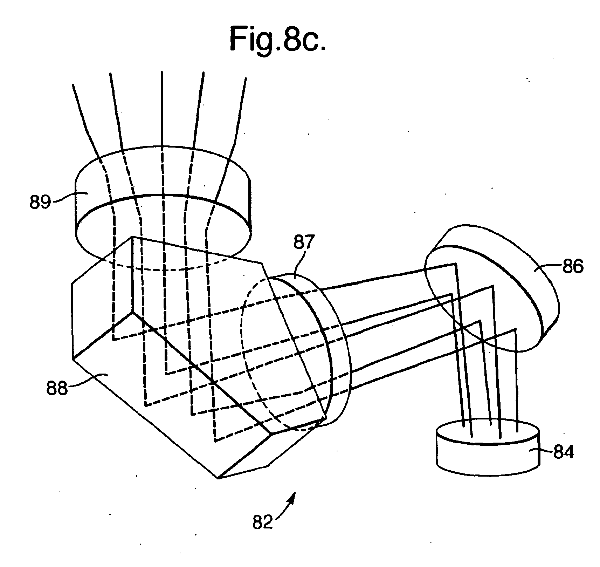

In an example not forming part of the invention, a passive reticle-shaped tool contains multiple optical channels. First, as discussed further below with respect to Figures 8(b) and 8(c), it is preferable that at least four different channels each having a different rotation angle of the retarder be used for each field point. In addition, in order to select field points in an x direction, these optical channels are copied and positioned in the x direction on the reticle. The present reticle-y-movement can be used to position the different channels in the y direction.

Because different channels are used to measure polarization at one field point, these channels (with their optical paths) should be calibrated.

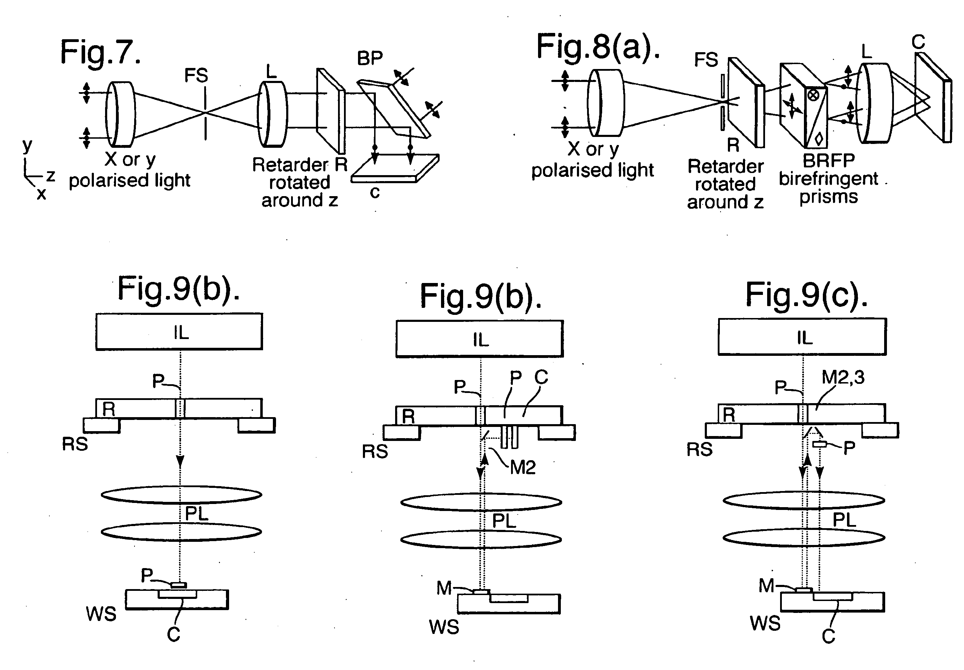

Several variants can be found where, after retardation by a retarder at a fixed angle, the polarizations are split before being measured. This can be done by for example a Brewster plate BP (Fig. 7) or birefringent prisms BRFP, based on a Wollaston prism (Fig. 8(a)).

A Brewster plate is a plate operated at Brewster's angle (also known as Polarization angle). When light moves between two media of differing refractive index, light which is *p*-polarized with respect to the interface is not reflected from the interface at one particular incident angle, known as Brewster's angle.

It may be calculated by:

$$\theta_B = \arctan\left(\frac{n_2}{n_1}\right),$$

where $n_1$ and $n_2$ are the refractive indices of the two media.

Note that, since all *p*-polarized light is refracted, any light reflected from the interface at this angle must be *s*-polarized. A glass plate placed at Brewster's angle in a light beam can thus be used as a polarizer.

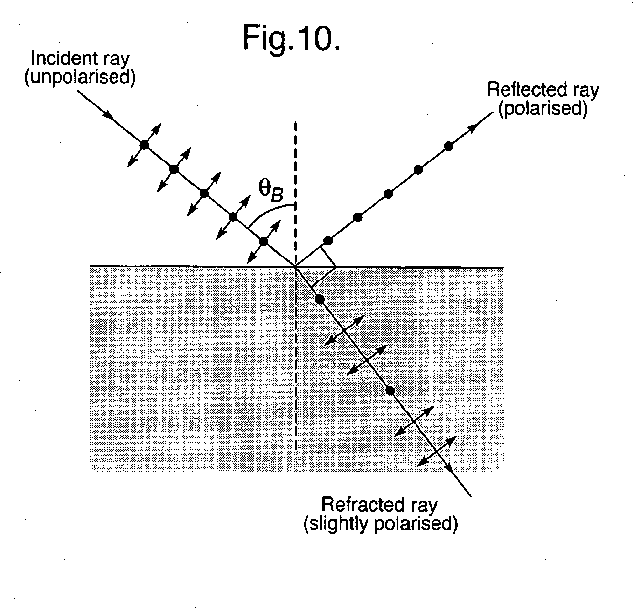

Figure 10 depicts interaction of an unpolarized light wave with a surface. For a randomly polarized ray incident at Brewster's angle, the reflected and refracted rays are at 90° with respect to one another.

For a glass medium ($n_2 \approx 1.5$) in air ($n_1 \approx 1$), Brewster's angle for visible light is approximately 56° to the normal. The refractive index for a given medium changes depending on the wavelength of light, but typically does not vary much. The difference in the refractive index between ultra violet ($\approx 100$nm) and infra red ($\approx 1000$nm) in glass, for example, is $\approx 0.01$.

The Wollaston prism is a useful optical device that manipulates polarized light. It separates randomly polarized or unpolarized incoming light into two orthogonal, linearly polarized outgoing beams. Since the beams are separated in space, the intensity of the two different beams can be measured at a detector and can be used to give information about the polarization of the light. For example, the prism can be configured to give horizontally and vertically polarized beams, wherein the difference in intensity of beams at the two different orientations measured at the detector corresponds to the Stokes parameter S1 (see above).

The Wollaston prism consists of two orthogonal birefringent prisms, such as calcite prisms, cemented together on their base to form two right triangle prisms with perpendicular optic axes. Outgoing light beams diverge from the prism, giving two polarized rays, with the angle of divergence determined by the prisms' wedge angle and the wavelength of the light. Commercial prisms are available with divergence angles from 15° to about 45°.

The extinction ratio of both elements is estimated to be more than 1:300.

Figure 8(b) illustrates a passive reticle system 80 . System 80 includes a 3X4 array of polarization sensor modules 82. Sensor modules 82 include field stops 84 that are configured to admit light into the sensor module. Figure 8(c) illustrates details of a polarization sensor module 82. Light passing through field stop 84 is reflected off mirror 86, passes through fixed retarder 87, and is reflected off of Brewster plate polarizer (prism polarizer) to emerge through collimator lens 89. Reticle system 80 is preferably configured to be interchangeable with a reticle used in a lithography tool. When tool 80 is placed in a reticle stage, field stops 82 sample different field points. In one configuration, each of the four sensor modules within a "column" is configured with a different effective retarder. In other words, a detector measuring light emerging from all four sensor modules 82 within a column receives light that is subject to four different amounts of retardation. The reticle system is preferably configured to translate within a field of illuminator radiation, for example, by applying an x- or y-movement to a reticle stage. By applying a translation movement along a direction parallel to a four sensor module column, each sensor module can intercept a common field point, and a series of four measurements corresponding can therefore be recorded corresponding to one measurement each for each sensor module of the column. Accordingly, four different retardation conditions can be recorded for a given field point. Thus, complete polarization information corresponding to the position of each column can be obtained in principle by appropriate configuration of the retarders within each column. Preferably, each polarization sensor module is provided with a movable shutter that can block radiation from the illuminator, such that a single sensor module can be designated to receive radiation from the illuminator at a given time, while radiation is simultaneously blocked from entering other sensor modules.

In one configuration, as illustrated in Figure 8(b), three columns of sensor modules 82 are arranged in an asymmetric fashion on a reticle system 80. In the example shown, each column represents a fixed Y position with respect to an illuminator. Thus, reticle system 80 can be used to measure at least three different Y field positions. By swapping reticle system 80 for another 3-colunmn system having a different configuration of column positions with respect to the Y direction, a total of 6 different y positions can be measured with a single exchange of reticles.

In the configurations illustrated in Figures 7 and 8(b), for example, a detector could be arranged near the collimating lens. However, in one configuration, the detector is arranged at a wafer level to receive radiation after it is reflected from a Brewster plate. In the latter case, the reflected light passes through a projection lens before being detected. As described below, other configurations provide for independent measurement of the effect on polarization of the projection lens.

B. Projection lens polarization sensor

In general, the projection lens can influence the polarization state of the light that passes through the projection lens. The final polarization of the light after passing through the projection lens also depends on the illuminator polarization settings and on which position of the lens is exposed. The contribution of the projection lens to the polarization state can be measured using the illuminator polarization sensor at reticle level (on active or passive reticle) and additional optics that treat the polarization at the reticle and/or wafer level. Three configurations, including a one-pass system, two-pass system and three-pass system are shown in Figs. 9a-c. For convenience, only one light path is shown through the center of the lens. Preferably, before the projection lens polarization contribution is measured, the standard illuminator polarization states is defined and fine-tuned by an illuminator polarization sensor, so the input polarization states (polarization states of light entering the projection system) are exactly known. In one aspect, at least four well-defined input polarization states (in terms of Stokes vectors) are used.

One-Pass System

For the one-pass system (see Fig. 9(a)), the illuminator IL light which has a well known polarization state passes a pinhole P at reticle level, followed by the projection lens PL, optional rotating retarder (not shown) and then a polarizer P at wafer level positioned at a close distance above a camera C located at wafer level WS. In one configuration, the light passes through a collimator and rotating retarder (not shown) before entering the polarizer.

Fig. 9(b) illustrates one configuration that employs a two-pass system. The light passes through the projection a second time after being reflected by a mirror located at the wafer level, and passes through a rotating retarder (not shown for simplicity) and a polarizer P located at the reticle level, where a camera detects the intensity of the polarized light. This wafer level mirror M displaces the incoming beam in an (x,y) (horizontal) direction so a reflected beam can be received by a mirror at reticle level, after which it is detected by the camera. For example, this could be performed by arranging the wafer level mirror as a cube edge mirror. The x-y displacement is kept minimal to ensure approximately the same optical path through the lens for light passing the projection lens the first time and the second time. In other words, light incident on the wafer level mirror M can be displaced slightly horizontally at the mirror level and reflected in a direction opposite but substantially parallel to the incident light. In this manner the path length, direction, and position within the projection lens PL are substantially the same for both the incident and reflected light beams. The ability to produce substantially similar incident and reflected beams depends on the position and alignment of the mirror at reticle level with respect to the rest of the optical parts. The accurate determination of the position and alignment of the mirror at reticle level with respect to the rest of the optical parts can be done beforehand outside the wafer scanner. In the two pass configuration, there is no need to position a detector/polarizer system at the wafer stage level, as illustrated in Figure 9(b).

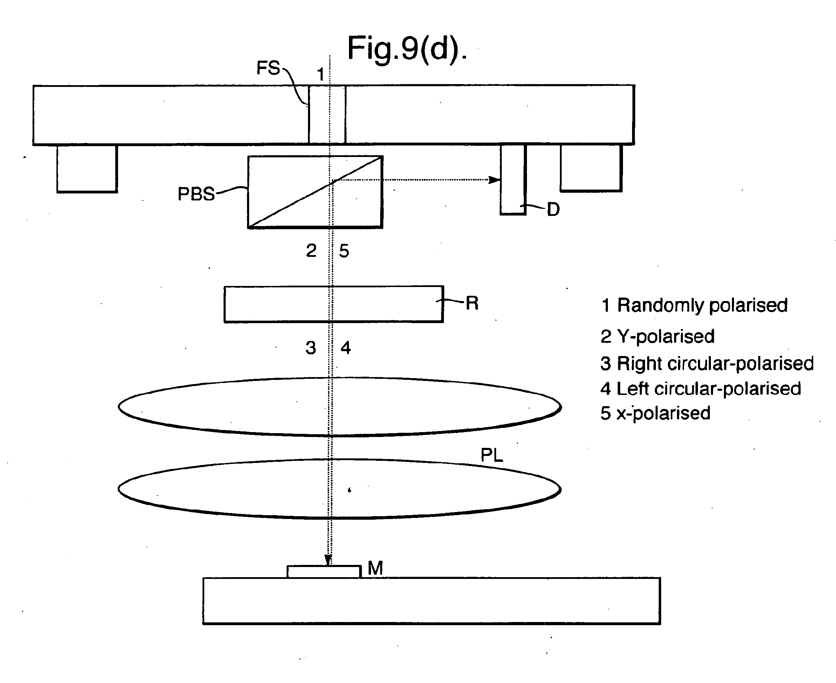

In another two-pass configuration, a first beam of light impinging on the wafer level mirror M is reflected back towards the reticle level as a second beam of light without undergoing any substantial x-y translation at the wafer level, thus substantially overlapping the second beam of light. In this configuration, the second beam of light attains an optical attribute different than the first beam of light, such that the second beam of light can be directed to a polarizer and camera, as illustrated in Figure 9(b). For example, as further illustrated in Figure 9(d), a beam splitting polarizer PBS is provided below a pinhole FS supplied at a reticle. In one example, randomly polarized light 1 entering the beam splitter PBS is Y-polarized 2 after leaving the polarizing beam splitter. After exiting the beam splitter the light passes through a retarder R (such as a quarter wave plate) and assumes a circular polarization, shown as a right handed circular polarization 3 in Figure 9(d). After reflection from the wafer level mirror M, the light assumes a left handed circular polarization 4, travels though the quarter wave plate, and becomes x-polarized 5, such that the light reflects from the beam splitter PBS to the detector D provided at reticle level. Accordingly, the reflected light need not be translated in an x-y direction at the wafer level in order to be detected by the reticle level detector. It is to be noted that the projection lens can in general affect circularly polarized light, such that the light becomes elliptically polarized, such that light 4 entering the quarter wave plate may be elliptically polarized rather than circularly polarized. However, such effects can be accounted for and in fact provide information about the affect on polarization of the projection lens.

In configurations employing a three-pass system (see Fig. 9(c)), the light passes through a projection lens three times. In the configuration illustrated in Figure 9(c}, after being reflected the first time by a mirror M at the wafer level, is reflected a second time by a mirror M2 positioned at the reticle level, after which it is reflected back toward the wafer stage by mirror M3, passing through and being treated by a polarizer P, and measured by a detector positioned at the wafer level WS (such as a camera C). As illustrated, a polarizer need not be located near the detector at the wafer level, but can be located at the reticle level.

Additionally, a three pass system having optical elements that permit reflection of a first beam without any horizontal displacement is possible, as described above for a two-pass configuration.

As illustrated in Figures 9(b) and 9{c), almost all optics used to perform the projection lens polarization measurements are included in the reticle tool, so that they need not be present in the wafer scanner, when not performing measurements. The reticle tool can be taken out of the wafer scanner for instance to calibrate the position of the two optical mirrors on the tool. This will increase the measurement quality.

In all three systems (one-pass, two-pass and three-pass) a collimating lens (not shown) can be used in front of the polarizer. This reduces the requirements for the polarizing element to have small retardation errors for incident light under high NA values.

The one-pass system has the advantage of using an existing camera at the wafer level. The two-pass system employs a separate camera at reticle level. One advantage of the two pass configuration as illustrated in Figure 9(b) is that most of the optical components, including the reticle with pinhole, polarizer, camera, reticle level mirror (but not including the wafer stage reflector (mirror)) can be configured to be part of a loadable reticle-shaped tool. The reflector can be positioned anywhere on the wafer stage, since the camera at wafer level is not in use.

It is to be further noted that, in the configuration of the three pass system illustrated in Figure 9{c), the measured polarization effect exerted by the projection lens is essentially the same as the two-pass configuration. In other words, the polarizer in both 9(b) and 9(c) is positioned to intercept light after passing through the projection lens twice. Once exiting the polarizer, as shown in Figure 9{c), the intensity of the polarized light, which is what is measured by the detector, should not be sensitive to whether the light passes through the projection lens.

It would be appreciated by those of ordinary skill in the art that the present invention could be embodied in other specific forms without departing from the spirit or essential character thereof. The presently disclosed embodiments are therefore considered in all respects to be illustrative and not restrictive. For instance the invention also applies to wafer steppers, which are just like wafer scanners lithographic apparatus, or lithographic apparatus for flat panel displays, PCB's etc. Also the invention applies to reflective optics as well.

Other embodiments, uses and advantages of the invention will be apparent to those skilled in the art from consideration of the specification and practice of the invention disclosed herein. The specification should be considered exemplary only, and the scope of the invention is accordingly intended to be limited only by the following claims. The descriptions above are intended to be illustrative, not limiting. Thus, it will be apparent to one skilled in the art that modifications may be made to the invention as described without departing from the scope of the claims set out below.

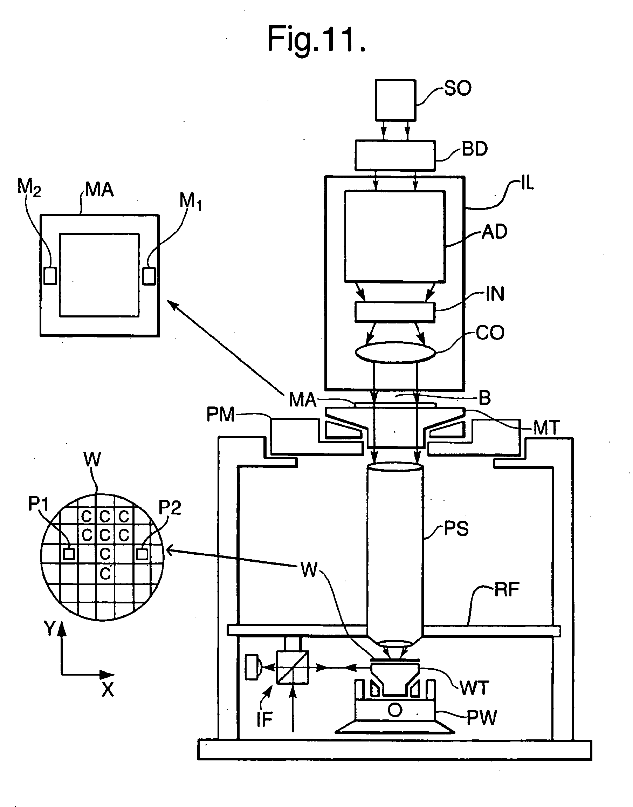

Figure 11 schematically depicts a lithographic apparatus according to the embodiments of the invention. The apparatus of Figure 11 comprises: an illumination system (illuminator) IL configured to condition a radiation beam PB (e.g. UV radiation or EUV radiation); a support structure (e.g. a mask table) MT constructed to support a patterning device (e.g. a mask) MA and connected to a first positioner PM configured to accurately position the patterning device in accordance with certain parameters; a substrate table (e.g. a wafer table) WT constructed to hold a substrate (e.g. a resist-coated wafer) W and connected to a second positioner PW configured to accurately position the substrate in accordance with certain parameters; and -a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein at least a portion of the substrate may be covered by a liquid having a relatively high refractive index, e.g. water, so as to fill a space between the projection system and the substrate. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 11, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section. The illuminator may also control the polarization of the radiation, which need not be uniform over the cross-section of the beam.

The radiation beam B is incident on the patterning device (e.g., mask MA), which is held on the support structure (e.g., mask table MT), and is patterned by the patterning device. Having traversed the mask MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:

1. In step mode, the mask table MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the mask table MT and the substrate table WT are scanned synchronously while a pattern imparted to the radiation beam is projected onto a target portion C (i.e. a single dynamic exposure). The velocity and direction of the substrate table WT relative to the mask table MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.

3. In another mode, the mask table MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

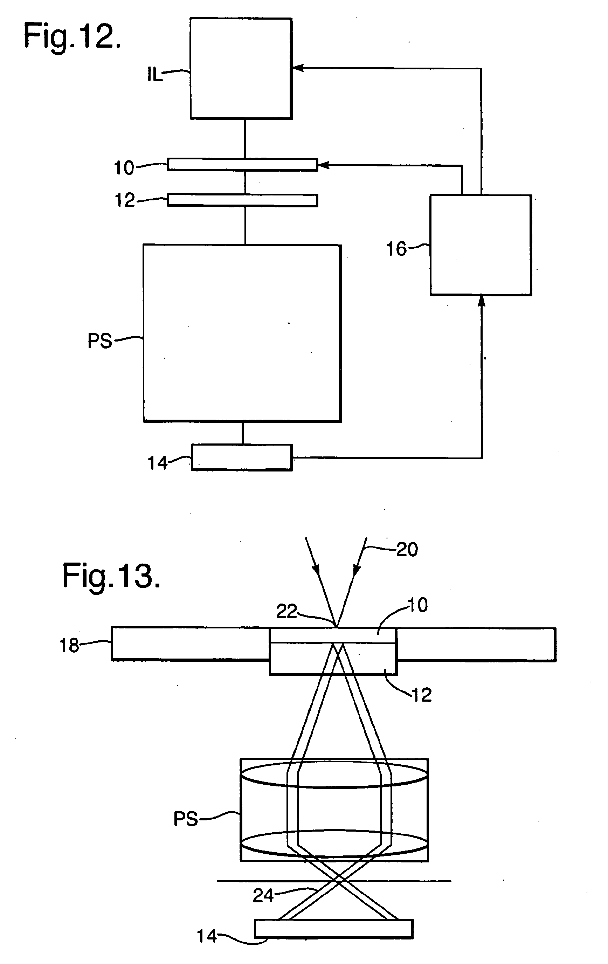

An embodiment of the present invention is illustrated in Figure 12, depicting schematically an arrangement for measuring the state of polarization of the projection radiation at the level of the reticle. The illuminator IL and projection system PS, as in Figure 11, are indicated. At the level of the reticle, and interposed into the beam path are an adjustable polarization changing element 10 followed by a polarization analyzer 12. In this example, the analyzer 12 is a linear polarizer, such as a beam-splitter cube, in a first fixed rotational orientation to transmit only the component of the radiation having an electric field vector in a specific direction. The polarization changing element 10 is a retarder, or retardation plate, and is, in an embodiment, a quarter-wave plate for the particular wavelength of illumination radiation. A quarter-wave plate introduces a relative phase shift of B/2 between orthogonally linearly polarized components of incident radiation. This can convert suitably oriented linearly polarized radiation to circularly polarized radiation and vice versa. In general, it changes a general elliptically polarized beam into a different elliptically polarized beam.

The polarization changing element 10 is adjustable such that the polarization change induced can be varied. In one form of adjustment, the polarization changing element 10 is rotatable such that the orientation of its principal axis can be adjusted. In another form of this example, the polarization changing element 10 is replaceable by a number of differently oriented polarization changing elements which can each be inserted in the beam path. The polarization changing element 10 can be completely removable and replaceable by a differently oriented polarization changing element 10, or a plurality of differently oriented polarization changing elements may be provided integrally on a carrier, similar to a reticle, for example in the form of an array. By translating the carrier then the polarization changing element corresponding to any particular field point can be adjusted.

A detector 14 for detecting the intensity of the radiation is provided in the invention after the radiation has passed through the projection system PS. The detector 14 can be a pre-existing detector provided at the substrate table. One form is a spot sensor which measures the radiation intensity at a particular field point. Another form is a CCD camera that is provided for wavefront measurements. The CCD camera can be provided with a small aperture or pinhole at the focal plane of the projection system to select a desired field point. The CCD sensor itself is then defocused such that each pixel of the CCD detects radiation that has traversed a specific path through the projection system to reach that field point; in other words each pixel corresponds to a point in the pupil plane of the projection system (or pupil plane of the illuminator).

The arrangement of a rotatable quarter-wave plate followed by a linear polarizer and a detector is known in the field of ellipsometry to yield the state of polarization of the input radiation, e.g., the radiation at the level of the reticle. A number of intensity measurements are taken at different rotational orientations of the quarter-wave plate and these can be converted to quantify the state of polarization expressed according to a suitable basis, such as the Stokes parameters to provide the Stokes vector characterizing the radiation. Further details regarding ellipsometry and obtaining Stokes parameters can be found in any suitable optics text book, such as Principles of Optics, M Born & E Wolf, Seventh Edition, Cambridge University Press (1999). At least three intensity measurements are required corresponding to three rotational positions of the quarter-wave plate. Although there are four Stokes parameters, there is some redundancy between them, so three measurements can determine them at least normalized with respect to the overall intensity of the radiation.

According to an embodiment of the present invention, a controller 16 receives measurements from the detector 14, which in conjunction with the control and/or detection of the adjustment of the polarization changing element 10, such as its rotational orientation, can calculate the state of polarization e.g. Stokes parameters, for each pupil pixel. The detector can be moved and the measurements repeated for different field points.

The question arises concerning how this may still work when the detector 14 does not immediately follow the analyzer 12 (such a position being the ideal detector position). Instead, there is the projection system PS with its unknown polarization effect. However, it should be appreciated that the analyzer 12 closely follows the polarization changing element 10; and it does not matter that there are further components between the analyzer 12 and the detector 14 because the detector 14 is insensitive to polarization variation. The situation can be considered in the following way. If the radiation exiting the polarization changing element 10 has a state of polarization represented by the Stokes vector $S_{in}$ then the state of polarization following the analyzer 12, called $S_{out}$, can be found by multiplying $S_{in}$ by the Müller matrix $M_{pol}$ representing the operation of the analyzer 12 (linear polarizer). The coordinate system can be arbitrarily chosen such that the analyzer 12 is a polarizer in the X-direction. Thus the state of polarization (Stokes vector) of the radiation at the ideal detector position is as follows:

$$S_{out} = M_{pol}.S_{in} = \frac{1}{2}\begin{pmatrix} 1 & 1 & 0 & 0 \\ 1 & 1 & 0 & 0 \\ 0 & 0 & 0 & 0 \\ 0 & 0 & 0 & 0 \end{pmatrix}\begin{pmatrix} S_0 \\ S_1 \\ S_2 \\ S_3 \end{pmatrix} = \frac{1}{2}\begin{pmatrix} S_0 + S_1 \\ S_0 + S_1 \\ 0 \\ 0 \end{pmatrix} \quad (1)$$

The irradiance as measured by the detector is given by the first element of the Stokes vector, and so is:

$$I_{det} = \tfrac{1}{2}\left(S_0 + S_1\right) \quad (2)$$

Now for the real situation illustrated in Figure 12, we can use a general Müller matrix $M_{gen}$ to represent the effect of the projection system and indeed any non-idealities of the detector.

$$S_{out} = M_{gen}.M_{pol}S_{in} = \begin{pmatrix} m_{11} & m_{12} & m_{13} & m_{14} \\ m_{21} & m_{22} & m_{23} & m_{24} \\ m_{31} & m_{32} & m_{33} & m_{34} \\ m_{41} & m_{42} & m_{43} & m_{44} \end{pmatrix}\frac{1}{2}\begin{pmatrix} 1 & 1 & 0 & 0 \\ 1 & 1 & 0 & 0 \\ 0 & 0 & 0 & 0 \\ 0 & 0 & 0 & 0 \end{pmatrix}\begin{pmatrix} S_0 \\ S_1 \\ S_2 \\ S_3 \end{pmatrix}.$$

$$= \begin{pmatrix} m_{11} & m_{12} & m_{13} & m_{14} \\ m_{21} & m_{22} & m_{23} & m_{24} \\ m_{31} & m_{32} & m_{33} & m_{34} \\ m_{41} & m_{42} & m_{43} & m_{44} \end{pmatrix}\frac{1}{2}\begin{pmatrix} S_0 + S_1 \\ S_0 + S_1 \\ 0 \\ 0 \end{pmatrix} = \frac{1}{2}\begin{pmatrix} m_{11}\left(S_0 + S_1\right) + m_{12}\left(S_0 + S_1\right) \\ m_{21}\left(S_0 + S_1\right) + m_{12}\left(S_0 + S_1\right) \\ 0 \\ 0 \end{pmatrix} \quad (3)$$

So the irradiance as measured by the detector is:

$$I_{det} = \tfrac{1}{2}\left(m_{11} + m_{12}\right)\left(S_0 + S_1\right) \quad (4)$$

So this is equal to the previous result with an ideal detector immediately following the analyzer, apart from a factor $(m_{11}+m_{12})$, where $m_{11}$ and $m_{12}$ are elements of the Müller matrix representing the projection system. Thus, the measurements taken by the detector 14 are unaffected apart from a constant factor, and it is not necessary to know the value of this factor because it cancels out in the ellipsometry calculation. Thus the polarization properties, such as polarization degree and polarization purity at the level of the reticle can be completely determined. The influence of the projection system is almost completely eliminated by having the polarizer 12 at reticle level; only the intensity is altered. Thus, polarization changing element 10, analyzer 12, and detector 14, together comprise an illumination polarization sensor having a detector located at the wafer level rather than reticle level.

As explained above, it is not necessary to know the value of the factor $(m_{11}+m_{12})$. However, it can be useful to have this information, in particular when the value of this factor is not constant over the pupil area. If it varies over the pupil area, then the operator cannot tell whether this is due to polarization properties of the projection system or due to imperfections in the illumination radiation. For example, with a quadrupole illumination mode in combination with tangential polarization, two poles may appear less bright than the other two poles. This may either be caused by asymmetries in the illumination system or by a residual linearly polarizing effect of the projection system. By determining the cause, appropriate corrections can be made. To determine the cause (said asymmetry or said residual polarizing effect), the analyzer 12 is rotated to a second fixed rotational orientation and the Stokes parameters are measured again. From the two measurement sets, one can identify the contribution of the projection system and the illumination system as separate entities.

Figure 13 shows a further embodiment of the invention. In this example the polarization changing element 10 and the analyzer 12 are integrated into a carrier 18 that can be inserted into the lithographic apparatus in place of a reticle. Radiation 20 from the illuminator is incident on a pinhole 22 comprising an aperture in an opaque layer, such as chromium, formed on the upper surface of the carrier 18. The polarization changing element 10 is, in an embodiment, a quarter-wave plate such as a low order quarter-wave plate to minimize its thickness, and can be made of a suitable material such as quartz. The analyzer 12 in this embodiment does not simply block or absorb one linear polarization component, but instead is a prism made of a birefringent material arranged such that the two orthogonal linearly polarized components are spatially separated, in other words it is a polarizing beam splitter. According to one form, the prism comprises two wedges of crystals of the birefringent material in contact with each other, but the orientation of the principal optical axis of the crystal in one wedge is in the X direction, and in the other wedge is in the Y direction (i.e. in the form of a Wollaston prism). A suitable birefringent material from which to make the prism, and which can be used with short-wavelength illumination radiation, is KDP (potassium dihydrogen phosphate).

The effect of the polarizing beam splitter as the analyzer 12 is that when looking from underneath into the illumination radiation, one sees two pinholes next to each other, the radiation from one pinhole being polarized along the X axis, and the radiation from the other pinhole being polarized along the Y axis. A second pinhole 24, which may be an integral part of the detector, can be positioned at the focal plane of the projection system to selectively transmit one polarized image of the first pinhole 22 and block radiation from the other. A defocused detector 14, such as a CCD, measures the intensity for a plurality of pixels corresponding to locations in the pupil plane of the projection system and illuminator.

With one of the polarized images not transmitted by the second pinhole 24, the apparatus can be used in exactly the same way as described for Figure 12 to determine the state of polarization of the illumination radiation at reticle level. The carrier 18 can be provided with a plurality of pinholes 22, polarization changing elements 10, and analyzers 12, with the polarization changing element 10 being at different rotational orientations, such as with its fast axis along the X direction, along the Y direction and at 45° to the X and Y directions. By translating the carrier 18, the polarization changing element corresponding to a particular field location can be adjusted, and ellipsometry measurements can be made as before. Moving the second pinhole 24 to select the orthogonally polarized radiation is equivalent to rotating the analyzer 12 of Figure 12 through 90°. Thus further measurements can be readily made to obtain information characterizing the state of polarization of the radiation. As also explained previously with reference to Figure 12, using the second pinhole 24 to select the two different polarizations enables one to separate the contributions of the projection system and the illuminator, but in this case it is not necessary to have a rotatable or removable/replaceable analyzer 12 because the polarizing beam splitter used as the analyzer 12 in Figure 13 simultaneously performs the function of two orthogonal linear polarizers.

A further embodiment for measuring the polarization properties of the projection system, will now be described. There has been proposed a measurement system for measuring wavefront aberrations of a projection system using the principle known as a "shearing interferometer". According to this proposal, different portions of the beam from a particular location at the level of the patterning device travel along different paths through the projection system. This can be achieved by a diffractive element located in the beam between the illumination system and the projection system. The diffractive element, such as a grating, also known as the object grating, diffracts the radiation and spreads it out such that it passes through the projection system along a plurality of different paths. The diffractive element is typically located at the level at which the patterning device, e.g. mask MA is located. The diffractive element can be a grating or can be an array of features of suitable size, and may be provided within a bright area in a dark field reticle, said area being small with respect to an object field size of the projection system (i.e., sufficiently small so that image aberrations are substantially independent of the position of an object point in that area). Such an area may be embodied as a pinhole. As explained above, the pinhole may have some structuring within, such as for example said object grating, or diffractive features such as grating patterns, or checkerboard patterns. However, this is in principle optional (for example, in the first embodiment of the present invention, pinholes can be used to select small portions of the field, and, in an embodiment, there is no structuring within the pinholes). A function of the pinhole and its optional internal structure is to define a preselected mutual coherence having local maxima of mutual coherence in the pupil of the projection system, whereby the preselected mutual coherence is related to the pinhole and its optional internal structure through a spatial Fourier transformation of the pinhole and its structure. Further information on patterns within the pinhole can be gleaned from U.S. patent application publication no. US 2002-0001088. One or more lenses may also be associated with the diffractive element. This assembly as a whole, located in the projection beam between the illuminator and the projection system will be referred to hereafter as the source module.

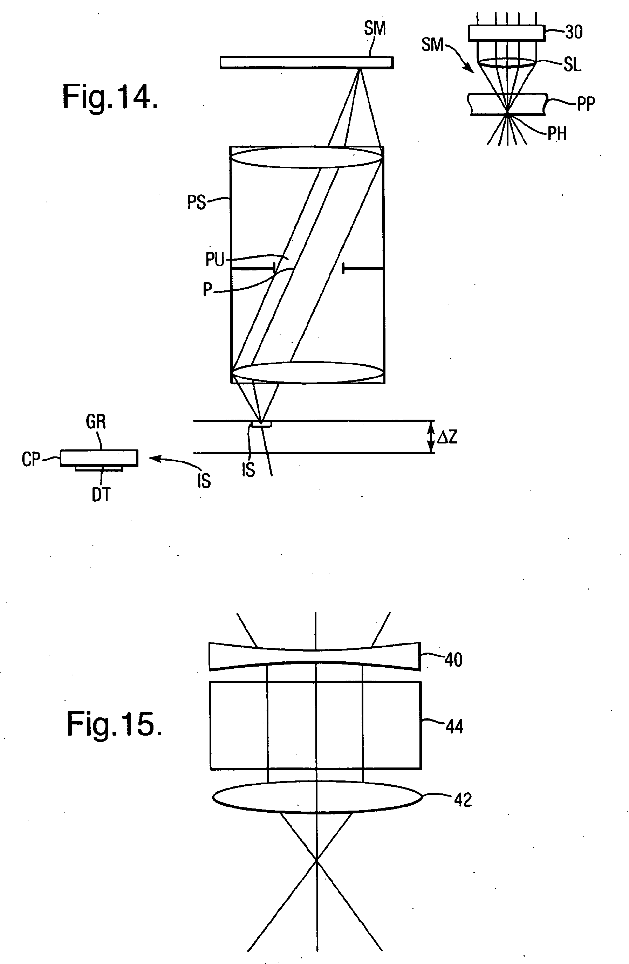

Referring to Figure 14, a source module SM is illustrated. It comprises a pinhole plate PP which is a quartz glass plate with an opaque chromium layer on one side, same as a reticle, and with a pinhole PH provided in the chromium layer. It also comprises a lens SL for focusing the radiation on to the pinhole. In practice an array of pinholes and lenses for different field positions and different slit positions are provided, and the lenses can be integrated on top of the pinhole plate. The source module should ideally generate radiation within a wide range of angles such that the pupil of the projection system is filled, or indeed overfilled, for numerical aperture measurements, and, in an embodiment, the pupil filling should be uniform. The use of the lens SL can achieve the over-filling and also increases the radiation intensity. The pinhole PH limits the radiation to a specific location within the field. Alternative ways to obtain uniform pupil filling are to use a diffuser plate (such as an etched ground glass plate) on top of the pinhole plate, or an array of microlenses (similar to a diffractive optical element DOE), or a holographic diffusor (similar to a phase-shift mask PSM).

Radiation that has traversed the source module and the projection system then impinges on a further diffractive element GR, such as a pinhole or a grating, known as the image grating. Referring to Figure 14, the further diffractive element GR is mounted on a carrier plate CP, for example made of quartz. This further diffractive element acts as the "shearing mechanism" that generates different diffractive orders which can be made to interfere (by matching diffracted orders to said local maxima of mutual coherence) with each other. For example, the zero order may be made to interfere with the first order. This interference results in a pattern, which can be detected by a detector to reveal information on the wavefront aberration at a particular location in the image field. The detector DT can be, for example, a CCD or CMOS camera which captures the image of the pattern electronically without using a resist. The further diffractive element GR and the detector DT will be referred to as the interferometric sensor IS. Conventionally, the further diffractive element GR is located at the level of the substrate at the plane of best focus, such that it is at a conjugate plane with respect to the first-mentioned diffractive element in the source module SM. The detector DT is below the further diffractive element GR and spaced apart from it.

One proprietary form of an interferometric wavefront measurement system implemented on lithography tools is known as ILIAS (trademark) which is an acronym for Integrated Lens Interferometer At Scanner. This measurement system is routinely provided on lithographic projection apparatus. Further information on such an interferometric system provided on a lithography scanner apparatus can be gleaned from U.S. patent application publication no. US 2002-0001088 and U.S. patent no. US 6,650,399 B2 .

The interferometric sensor essentially measures the derivative phase of the wavefront. The detector itself can only measure radiation intensity, but by using interference the phase can be converted to intensity. Most interferometers require a secondary reference beam to create an interference pattern, but this would be hard to implement in a lithographic projection apparatus. However a class of interferometer which does not have this requirement is the shearing interferometer. In the case of lateral shearing, interference occurs between the wavefront and a laterally displaced (sheared) copy of the original wavefront. In the present embodiment, the further diffractive element GR splits the wavefront into multiple wavefronts which are slightly displaced (sheared) with respect to each other. Interference is observed between them. In the present case only the zero and +/- first diffraction orders are considered. The intensity of the interference pattern relates to the phase difference between the zero and first diffraction orders.

It can be shown that the intensity I is given by the following approximate relation:

$$I \approx 4E_0E_1 \cos\left(2\pi i\left[\frac{k}{p} + \frac{1}{2}\left(W\left(\rho + \frac{1}{p}\right) - W\left(\rho - \frac{1}{p}\right)\right)\right]\right) \qquad (5)$$

where $E_0$ and $E_1$ are the diffraction efficiencies for the zero and first diffracted orders, $k$ is the phase stepping distance, $p$ is the grating periodicity (in units of waves), $W$ is the wavefront aberration (in units of waves) and $p$ is the location in the pupil. In the case of small shearing distances, the wavefront phase difference approximates the wavefront derivative. By performing successive intensity measurements, with a slight displacement of the source module SM with respect to the interferometric sensor IS, the detected radiation intensity is modulated (the phase stepping factor $k/p$ in the above equation is varied). The first harmonics (with the period of the grating as the fundamental frequency) of the modulated signal correspond to the diffraction orders of interest (0 & +/-1). The phase distribution (as a function of pupil location) corresponds to the wavefront difference of interest. By shearing in two substantially perpendicular directions, the wavefront difference in two directions is considered.

As well as phase measurements on the wavefront as described above, amplitude measurements can also be made. These are done by using a source at reticle level with a calibrated angular intensity distribution. One example is to use an array of effective point sources (with dimensions smaller than the wavelength of the radiation used), where each point source has an intensity distribution which is effectively uniform over the range of solid angles present within the projection system pupil. Other sources are also possible. Variations in detected intensity can then be related to attenuation along particular transmission paths through the projection system. Further information regarding amplitude measurements and obtaining the angular transmission properties of the projection system (also called apodization) are given in U.S. patent application no. US 10/935,741.

The above wavefront measurements (both phase and amplitude) are performed using a polarized radiation source. One embodiment, as shown in Figure 14, is to incorporate a polarizer 30, such as a beam splitter cube, into the source module SM; an alternative embodiment would be to use separate discrete insertable polarizers, for example insertable at the illuminator or reticle level. No modification of the interferometric sensor IS is required.

With the shearing interferometer arranged to provide a shear in the X direction, a wavefront *Wxx* is first measured using the source radiation linearly polarized in one direction, such as the X direction. The polarizer or source module is then rotated or exchanged/displaced, such that the radiation is linearly polarized in the Y-direction, and the new wavefront *Wxy* is then measured. For convenience, a single source module carrier can be provided with an unpolarized, a X-polarized and a Y-polarized source structure, and loaded as a normal reticle. The reticle stage is able to move freely in the scanning direction, so for each field point (normal to the scanning direction) the unpolarized, a X-polarized and a Y-polarized source structure can be provided.

The effect on polarized radiation of an optical element or combination of optical elements, such as the projection system, can be represented by a Jones matrix. The X and Y components of the electric field vector of incident and outgoing electromagnetic radiation are related by the Jones matrix as follows:

$$\begin{pmatrix} E_{x\_out} \\ E_{y\_out} \end{pmatrix} = \begin{pmatrix} J_{xx} & J_{xy} \\ J_{yx} & J_{yy} \end{pmatrix} \begin{pmatrix} E_{x\_in} \\ E_{y\_in} \end{pmatrix} \tag{6}$$

For lithographic apparatus projection systems, it is valid to assume that the off-diagonal elements in the Jones matrices are very small (i.e. practically zero) relative to the diagonal elements, in other words very little cross talk of X and Y polarization states occurs. Therefore using an X-polarized source enables the diagonal element $J_{xx}$ to be determined from the wavefront measurement, and using a Y-polarized source enables the diagonal element $J_{yy}$ to be determined from the wavefront measurements. Both phase and amplitude measurements of the wavefront are needed because each element of the Jones matrix is in general a complex number.

For a specific field point, a Jones matrix can be calculated for each pupil point in the projection system (each Jones matrix corresponding to the effect on polarization of a ray of radiation taking a particular path through the projection system). The source module and interferometric sensor can be moved to a different field point and a set of Jones matrices obtained. Thus each combination of field point and pupil point has its own specific Jones matrix.

One concern might be that the device in the source module for ensuring that the projection system pupil is over-filled, such as a diffusor, might result in mixing of polarization states. However, this is not expected to be a significant effect because the characteristic length scales of small-angle diffusors are typically about 0.05 mm. However, even if mixing should occur this can be straightforward to remedy by combining the X and Y wavefront measurements and solving a set of linear equations. Supposing a fraction *a* of polarization mixing occurs within the source module, the following set of equations is found:

$$W_{x\_meas} = (1-a).W_x + a.W_y$$

$$W_{y\_meas} = a.W_x + (1-a).W_y \tag{7}$$

The mixing factor *a* can be found either theoretically or by a calibration (done off-line) and then the equations can be resolved to find the desired X and Y polarized wavefronts *Wx* and *Wy.* The same procedure can also be applied if the polarizer used does not yield satisfactory polarization purity.

An indication of a state of polarization of the radiation beam at substrate level may be based on the specification of a target polarization state that is desired. A convenient metric is defined as the polarization purity (*PP*) or the percentage of polarized radiation that is in the targeted or preferred polarization state. Mathematically the polarization purity (*PP*) can be defined as:

$$PP = \left| E_{Target} \cdot E_{Actual} \right|, \tag{8}$$

where $E_{Target}$ and $E_{Actual}$ are electric field vectors of unit length.

Although *PP* is a valuable metric it does not completely define the illuminating radiation. A fraction of the radiation can be undefined or de-polarized, where the electric vectors rotate within a timeframe beyond an observation period. This can be classified as unpolarized radiation. If radiation is considered to be the sum of polarized radiation with an intensity $I_{polarized}$ and unpolarized radiation with an intensity $I_{unpolarized}$, whereby the summed intensity is $I_{Total}$, it is possible to define a degree of polarization (*DOP*) by the following equation:

$$DOP = \frac{I_{polarized}}{I_{Total}} = \frac{I_{polarized}}{I_{polarized} + I_{unpolarized}}. \qquad (9)$$

*DOP* may be used to account for unpolarized portions. Since unpolarized (and polarized) radiation can be decomposed into 2 orthogonal states, an equation for the total intensity in the preferred state (*IPS*) of polarization as a function of *DOP* and *PP* can be derived, i.e.,

$$IPS = \frac{1}{2} + DOP \cdot \left( PP - \frac{1}{2} \right). \qquad (10)$$

In a still further example , the measurement method of the embodiment described above with respect to figure 14, is arranged to examine and compute a spatial distribution of *IPS*. As in the previous embodiment, the wavefront *Wxx* is first measured using the source radiation linearly polarized in the X direction, and using an image grating GR with its lines and spaces oriented parallel to the Y direction, so that in the projection system pupil a wavefront shearing in the X direction is obtained. The polarizer 30 is then rotated or exchanged/displaced, such that the radiation is linearly polarized in the Y-direction, further the object grating is, as before, arranged to provide in the projection system pupil a wavefront shearing in the X direction, and the corresponding linearly polarized wavefront *Wxy* is then measured.

For example, a first pinhole PH1 with X polarization is used for the spatially resolved aberration measurement of the wavefront *Wxx*. This process is repeated with another pinhole PH2, with Y polarization, and with the same grating orientation as was provided with the pinhole PH1. This results in a second wavefront aberration measurement of the wavefront *Wxy*. The measurement results can be used to compute, spatially resolved in the pupil, a Jones matrix and the intensity in the preferred state (*IPS*).

In the following, a more detailed description of this measurement is presented. In a typical shearing interferometer the phase $\varphi(x, y)$ of the wavefront is measured using an object grating in the pinhole PH to provide a preselected spatial coherence in the pupil of the projection system, and a shearing grating. The shearing grating is the image grating GR mentioned above. The grating GR brings different diffraction orders together on a detector DT. The detector DT will detect an intensity which oscillates with displacement of the grating GR relative to the pupil. The amplitude of oscillation will also be referred to as a contrast, and the average intensity (at amplitude zero) will also be referred to as a DC signal.

The shearing interferometric aberration measurement method includes a mixing (i.e., a coherent addition) of electric fields diffracted at the grating GR, including a zeroth order diffracted electric field and a first order diffracted electric field. The zeroth and first order diffracted fields are images of the electric field at the pupil of the projection system, and are respectively denoted by an electric field $E_0 (x, y)$ at a pupil-position $(x, y)$ in the pupil of the projection system and an electric field $E_1 (x + dx, y)$ at a "neighbor" pupil-position $(x + dx, y)$ .

Here the electric fields are scalar fields (with a same state of polarization, independent of the X, Y coordinates in the pupil) and the subscripts refer to the order of diffraction at the grating GR; the vector nature of polarization is introduced below. If terms which are constant over the wavefront are factored out, one obtains:

$$E_0(x, y) = A_0(x, y) \exp[i\varphi(x, y)],$$

and

$$E_1(x + dx, y) = A_1(x + dx, y) \exp[i\varphi(x + dx, y)]. \qquad (11)$$

The detector DT measures an intensity I(x,y) given by:

$$I(x,y) = (E_0 + E_1)(E_0 + E_1)^* = A_0^2 + A_1^2 + 2A_0 A_1 \cos[\varphi(x + dx, y) - \varphi(x, y)].\qquad(12)$$

The intensity $I(x,y)$ varies as a cosine with respect to the phase difference between the two fields $E_0$ and $E_1$. Note that $A_0 = A_0(x, y)$ and $A_1 = A_1(x + dx, y)$ ; the shorter notation is introduced to make the formulas more transparent. The wavefront-measurements include measuring the cosine-behavior by introducing an extra, varying "stepping" phase $\varphi_{step}$. At each step a new value of the intensity at one pixel of the detector DT is measured. After having stepped 8 times with $\varphi_{step} = k \times (2\pi/8)$, k=1, 2... 8, one gets the following eight measurements:

$$I_1(x,y) = A_0^2 + A_1^2 + 2A_0 A_1 \cos[d\varphi(x,y) + 1 \times (2\pi/8)],$$

$$I_2(x,y) = A_0^2 + A_1^2 + 2A_0 A_1 \cos[d\varphi(x,y) + 2 \times (2\pi/8)],$$

$$I_8(x,y) = A_0^2 + A_1^2 + 2A_0 A_1 \cos[d\varphi(x,y) + 8 \times (2\pi/8)].\qquad(13)$$

From these eight data points the phase $d\varphi(x, y) = \varphi(x + dx, y) - \varphi(x, y)$ can be extracted. Alternatively either more or less than eight data points can be used, depending on signal/noise constraints. A fit for every eligible pixel of the detector DT corresponding to a pupil position $(x,y)$ results in a full map $d\varphi(x,y)$ of the wavefront phase-shifts.

In order to describe birefringence, for example as occurring in lens elements of the projection system, the vector nature of the electric field is to be included. It is assumed that the shearing grating GR is non-polarizing, so that only vector properties of the radiation upstream of the grating GR are examined. Both $\bar{E}_0$ and $\bar{E}_1$ have now X and Y components parallel to orthogonal X and Y directions:

$$\bar{E}_0(x,y) = \begin{pmatrix} E_{0x}(x,y) \\ E_{0y}(x,y) \end{pmatrix} = \begin{pmatrix} A_{0x}(x,y)\exp[i\varphi(x,y)] \\ A_{0y}(x,y)\exp[i(\varphi(x,y) + \varphi_{ret}(x,y))] \end{pmatrix},\qquad(14)$$

and

$$\bar{E}_1(x+dx,y) = \begin{pmatrix} E_{1x}(x+dx,y) \\ E_{1y}(x+dx,y) \end{pmatrix} = \begin{pmatrix} A_{1x}\exp[i\varphi(x+dx,y)] \\ A_{1y}\exp[i(\varphi(x+dx,y) + \varphi_{ret}(x+dx,y))] \end{pmatrix}.\qquad(15)$$

An extra phase $\varphi_{ret}(x, y)$ describes a phase retardation between Y-components of each electric field due to for example birefringence. The phase retardation between X-components is absorbed by the previously introduced phase difference $\varphi(x, y)$. The intensity measured with a detector pixel of the detector DT is given by:

$$I(x,y) = (E_{0x} + E_{1x}, E_{0y} + E_{1y})^\bullet \times \begin{pmatrix} E_{0x} + E_{1x} \\ E_{0y} + E_{1y} \end{pmatrix} \qquad , \quad (16)$$

$$= A_{0x}^{\ 2} + A_{1x}^{\ 2} + A_{0y}^{\ 2} + A_{1y}^{\ 2} + 2A_{0x}A_{1x}\cos[d\varphi] + 2A_{0y}A_{1y}\cos[d\varphi + d\varphi_{rel}]$$

with $A_{0x} = A_{0x}(x, y)$ etc.

This result can be written as

$$I(x,y) = A_{0x}^{\ 2} + A_{1x}^{\ 2} + A_{0y}^{\ 2} + A_{1y}^{\ 2} + 2A_{BF}^{\ 2}\cos[d\varphi - d\varphi_{BF}], \quad (17)$$

where:

$$A_{BF}^{\ 2} = \sqrt{A_{0x}^{\ 2}A_{1x}^{\ 2} + A_{0y}^{\ 2}A_{1y}^{\ 2} + 2A_{0x}A_{1x}A_{0y}A_{1y}\cos[d\varphi_{rel}]}, \quad (18)$$

and

$$d\varphi_{BF}(x,y) = \arctan\left[\frac{-A_{0y}A_{1y}\sin[d\varphi_{rel}]}{A_{0x}A_{1x} + A_{0y}A_{1y}\cos[d\varphi_{rel}]}\right]. \quad (19)$$

An extra "birefringence term" $d\varphi_{BF}(x,y)$ has emerged in the cosine. This extra phase is detected by the shearing interferometric aberration measurement, and consequently it will be weighted by Zernike-coefficients expressing a wave aberration in terms of orthogonal normalized Zernike functions.

The polarization state of the electric field $E_0(x, y)$ is obtained from interferometric measurements of the intensity $I(x,y)$.

This polarization state is fully defined by the Stokes vector of $\overline{E}_0$, which is given by:

$$\vec{S}_{E_0}(x,y) = \begin{pmatrix} A_{0x}^{\ 2} + A_{0y}^{\ 2} \\ A_{0x}^{\ 2} - A_{0y}^{\ 2} \\ 2A_{0x}A_{0y}\cos[\varphi_{rel}] \\ 2A_{0x}A_{0y}\sin[\varphi_{rel}] \end{pmatrix}. \qquad (20)$$

The $I(x,y)$ measurements include the step of selecting two different, preselected polarization states for the radiation impinging on the object grating in the pinhole PH, for two corresponding $I(x, y)$ measurements.

In the following it is assumed that the radiation traversing the projection system is fully polarized, so that the degree of polarization $DOP_{E0}$ for $E_0(x,y)$ is 1:

$$DOP_{E_0}(x,y) = 1. \qquad (21)$$

The intensity in the preferred state (*IPS*) is equal to the polarization purity (*PP*) when *DOP* =1. Further, preferred states of polarization are defined as fully X-polarized polarization and fully Y-polarized polarization; these polarization states correspond to preferred illumination-modes for enhancing resolution of the lithographic printing process. The corresponding values for the *IPS* are:

$$IPS_x(x,y) = \frac{A_{0x}^{\;2}}{A_{0x}^{\;2} + A_{0y}^{\;2}}, \qquad (22)$$

and

$$IPS_y(x,y) = \frac{A_{0y}^{\;2}}{A_{0x}^{\;2} + A_{0y}^{\;2}}. \qquad (23)$$

It is assumed that, at a preselected position $(x_p, y_p)$ in the pupil of the projection system, the Jones matrix is known. For example, it may be assumed that for an axial ray along the optical axis of the projection system the Jones matrix is the unity matrix. Thus the electric field $\overline{E}_0 (x_p, y_p)$ remains unchanged after it traverses the reticle+projection system. In the present embodiment $\overline{E}_0 (x, y)$ is arranged to be linearly polarized in the X-direction at reticle level, by using a polarizer 30 with the source module SM, so that under the assumption of the unitary Jones matrix $A_{0y} = 0$ . In accordance with the equations 17 - 19, the following parameters can now measured in shearing-interferometry:

$$d\varphi_{BF,x} = \arctan[0] = 0, \qquad (24\text{-}1)$$

$$A_{BF,x}^{\;2} = A_{0x} A_{1x,x}, \qquad (24\text{-}2)$$

and

$$DC_x = A_{0x}^{\;2} + A_{1x,x}^{\;2} + A_{1y,x}^{\;2}. \qquad (24\text{-}3)$$

Here the index ",x" indicates the incident, linear X polarization. For example $A_{1y,x}$ is the amplitude of the Y-component of the first order diffracted electric field, when incident X-polarized radiation is used at reticle level. Next, the interferometric shearing measurement is repeated with an arrangement of the polarization of $E_0(x, y)$ taken to be linearly polarized in the Y-direction at reticle level, again by using a corresponding polarizer 30 in the source module aligned with the direction of polarization along the Y direction. In analogy with the previous measurement, $A_{0x} = 0$. In accordance with the general equations 17-19, one can now measure, using shearing interferometry, the following parameters:

$$d\varphi_{BF,y} = \arctan[\tan[d\varphi_{rel}]] = \varphi_{rel,y}(x + dx, y), \qquad (25\text{-}1)$$

$$A_{BF,y}{}^2 = A_{0y}A_{1y,y},\qquad\qquad(25\text{-}2)$$

and

$$DC_{,y} = A_{0y}{}^2 + A_{1x,y}{}^2 + A_{1y,y}{}^2.\qquad\qquad(25\text{-}3)$$

Again, ",y" sub-indexing is used to indicate the linear Y polarization of the incident radiation at reticle level, e.g. $A_{1x,y}$ is the amplitude of the X-component of the first order diffracted electric field, when incident Y-polarized radiation is used. In principle one can determine the full polarization state of $\overline{E}_1\,(x_p + dx, y_p)$ for incident X-polarization and incident Y-polarization.

The contrast of the interference pattern is related to the amplitude of the intensity oscillation as described by equations 24-2 and 25-2. Therefore, the measurement of the entities $A_{BF}{}^2$ is referred to as a "contrast" measurement. Further, a "DC" component of the interference fringe pattern is described by the equations 24-3 and 25-3. Accordingly, a measurement of $DC_{,x}$ and $DC_{,y}$ is referred to as a "DC" measurement. Said contrast and DC measurements lead to 4 equations with four unknowns $A_{1x,x}, A_{1x,y}, A_{1y,x}, A_{1y,y}$.

The position $(x_p + dx, y_p)$ may be referred to as a first position $(x_1, y_1)$ in the pupil. The above described measurement process can be repeated in going from the first position to a second position with $x_2 = x_1 + dx$, $y_2 = y_1$, to determine the corresponding amplitudes $A_{2x,x}, A_{2x,y}, A_{2y,x}, A_{2y,y}$, again using the equations 17 - 19 (with replacement of the subscripts 0 and 1 by 1 and 2 respectively) to obtain the four equations with four unknowns $A_{2x,x}, A_{2x,y}, A_{2y,x}, A_{2y,y}$. Similarly, shears in the Y direction may be introduced (by using an image grating GR with its lines and spaces oriented parallel to the X direction, so that in the projection system pupil a wavefront shearing in the Y direction is obtained). This enables transitions from first to second positions of the type $x_2 = x_1$, $y_2 = y_1 + d_y$.

Any such transitions to a neighboring position can be repeated an arbitrary number of times, each time determining the amplitudes $A_{ix,x}, A_{ix,y}, A_{iy,x}, A_{iy,y}$ with $i = 1, 2, 3$ etc., thereby effectively mapping out the spatial distribution of the state of polarization by integration. With use of equations 22 and 23, the corresponding spatial distribution of *IPS* can be obtained; for example, the distribution of $IPS_x(x,y)$ can be found by substituting the measured values of $A_{ix,x}$, $A_{iy,x}$ for $A_{0x}$, $A_{0y}$ in equation 22. ,

In the present embodiment, the two different settings of the polarizer 30 include a linear polarization along the direction of shear and a linear polarization perpendicular to the direction of shear. However, according to an aspect of the invention, additional settings of the polarizer 30 may be used. DC and contrast measurements as described above may further be executed with a polarization at reticle level different from either linear X polarization or linear Y polarization, by providing a source module SM with a polarizer 30 arranged for linear polarization at an angle different from zero or 90 degrees with respect to the direction of shear. Such additional measurements may be used to enhance the accuracy of the process of solving equations for the electric field amplitudes, as described above, or to obtain information on the presence of unpolarized radiation in the case that DOP <1.

According to still another embodiment a Jones matrix distribution can be measured in a similar way. As in the previous embodiment it is assumed that *DOP* = 1, so that the transfer functions describing a change of polarization state for radiation traversing the projection system can be represented as a spatial distribution of complex $2 \times 2$ Jones matrices. As in the previous embodiment, unknown electric field amplitudes are determined by measuring interferometric mixing data such as said DC components and contrasts, as well as by measuring $d\varphi$

These measurements are repeated for two input polarization states (such as, for example, linear X polarization and linear Y polarization, as in the previous embodiment). It is assumed that there is a single point in the pupil where the Jones matrix is known. For example, the Jones matrix may be assumed to be the unitary matrix for a point on the optical axis of the projection system.

Next, the Jones matrices in all other pupil points can be obtained by iteration analogous to the iteration described in the previous embodiment. Since each of the four matrix-elements of a Jones matrix has a real part and an imaginary part, there are 8 unknowns and hence, 8 equations are needed to solve for the unknowns. Six equations are provided by the fit of the interferometric intensity data to the equations 24-1, 24-2 and 24-3 and equations 25-1, 25-2 and 25-3. Two additional equations are provided by supplementary measurements of output intensities for the two polarization states of the radiation incident on the pinhole PH, for the first order diffracted beam, in the absence of interference with other diffracted beams.

The analysis presented in the description of the fourth and fifth embodiments is only for simplicity limited to the combination of two diffracted orders of radiation at the grating GR in a shearing interfrometer arrangement. However, according to an aspect of the present invention additional diffracted orders may be taken into account. For example, besides the electric fields $\overline{E}_0$ and $\overline{E}_1$ a diffracted field $\overline{E}_{-1}$ corresponding to a "neighbor" pupil-position ($x - dx$, $y$) can be included in the analysis. The analysis is analogous to the analysis of the fourth embodiment.

In any of the previously described embodiments in which polarization-active components are used, such as polarizers, retarders (quarter-wave plates), polarizing beam splitters and so on, the angle of propagation of the radiation may have a significant effect on the performance of the component. Therefore it is advantageous to locate these components at a place where the radiation is substantially collimated. One option is to locate the elements such as the polarization changing element 10 and the analyzer 12 at a suitable location in the illuminator where the radiation is already substantially collimated. A second alternative is to provide optical elements 40 and 42, as shown in Figure 15, which firstly collimate the radiation and then focus it. This provides a zone 44 in which the radiation is in the form of a collimated beam and in which the polarization-active components can be placed.

The results of the measurements according to any of the above embodiments of the invention can be used to provide feedback. For example, in an apparatus in which a desired polarization pattern is intended to be set by the illuminator, one or more actuators may be provided to adjust components of the lithographic apparatus by way of feedback based on the obtained measurements. Figure 12 illustrates, by way of example, that the illuminator IL may be adjusted under the control of the controller 16 to correct or compensate for any measured deviations in the desired polarization pattern.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications.

The terms "radiation" and "beam" used herein encompass all types of electromagnetic radiation, including ultraviolet (UV) radiation (e.g. having a wavelength of or about 365, 248, 193, 157 or 126 nm), extreme ultra-violet (EUV) radiation (e.g. having a wavelength in the range of 5-20 nm), and other types of radiation.

The term "lens", where the context allows, may refer to any one or combination of various types of optical components, including refractive, and reflective optical components.

While specific embodiments of the invention have been described above, it will be appreciated that the invention may be practiced otherwise than as described.

The descriptions above are intended to be illustrative, not limiting. Thus, it will be apparent to one skilled in the art that modifications may be made to the invention as described without departing from the scope of the claims set out below.

**Claims**

1. A lithographic apparatus comprising:

   an illumination system (IL) configured to condition a radiation beam;
   a support (NT) constructed to support a patterning device, the patterning device being capable of imparting the radiation beam with a pattern in its cross-section to form a patterned radiation beam;
   a substrate table (WT) constructed to hold a substrate;
   a projection system (PS) configured to project the patterned radiation beam onto a target portion of the substrate;
   an adjustable polarization changing element (10); and
   a polarization analyzer (12); wherein:

      the polarization changing element is a retarder;

the polarization changing element and the polarization analyzer are arranged in the path of the radiation beam in that order in the direction of propagation of the radiation beam at a level at which the patterning device would be supported by the support; and

the appartus further comprises a detector (14) for measuring the intensity of the radiation after it has passed through the adjustable polarisation changing element, the polarisation analyzer, and the projection system (PS).

2. A lithographic apparatus according to claim 1, wherein the polarization changing element (10) is adjustable by being rotatable and/or exchangeable.

3. A lithographic apparatus according to claim 1 or 2, wherein the polarization changing element (10) is a quarter-wave plate.

4. A lithographic apparatus according to claim 1 or 2, wherein the polarization analyzer (12) is a linear polarizer.

5. A lithographic apparatus according to claim 1 or 2, wherein the polarization analyzer is a polarizing beam-splitter arranged to output two orthogonally linearly polarized radiation components, spatially separated from one another.

6. A lithographic apparatus according to claim 5, wherein the polarization analyzer (12) consists essentially of KDP.

7. A method for determining at least one polarization property of a lithographic apparatus having a projection system (PS), the method comprising:

using a detector (14) to take intensity measurements for a plurality of different settings of a polarization changing element (10) of the lithographic apparatus, the polarization changing element (10) being a retarder and positioned in the path of the radiation before a polarization analyzer (12), the polarization changing element (10) and polarization analyser (12) being positioned before the projection system (PS); and

determining, from the intensity measurements, information on a state of polarization of the radiation before it encounters the polarization changing element; wherein

the detector is positioned after the projection system (PS) and takes intensity measurements that are insensitive to polarization variations imparted by the projection system (PS).

**Patentansprüche**

1. Ein lithographisches Gerät, das Folgendes beinhaltet:

ein Beleuchtungssystem (IL), das konfiguriert ist, um einen Strahlungsstrahl zu konditionieren;

eine Stütze (NT), die konstruiert ist, um eine Musteraufbringungsvorrichtung zu stützen, wobei die Musteraufbringungsvorrichtung in der Lage ist, dem Strahlungsstrahl in seinem Querschnitt ein Muster zu verleihen, um einen gemusterten Strahlungsstrahl zu bilden;

einen Substrattisch (WT), der konstruiert ist, um ein Substrat zu halten;

ein Projektionssystem (PS), das konfiguriert ist, um den gemusterten Strahlungsstrahl auf einen Zielabschnitt des Substrats zu projizieren;

ein verstellbares Polarisationsänderungselement (10); und

einen Polarisationsanalysator (12); wobei:

das Polarisationsänderungselement ein Verzögerer ist;

das Polarisationsänderungselement und der Polarisationsanalysator in dieser Reihenfolge in der Richtung der Ausbreitung des Strahlungsstrahls auf einer Höhe, auf der die Musteraufbringungsvorrichtung von der Stütze gestützt würde, in dem Weg des Strahlungsstrahls eingerichtet sind; und

das Gerät ferner Folgendes beinhaltet: einen Detektor (14) zum Messen der Intensität der Strahlung, nachdem sie durch das verstellbare Polarisationsänderungselement, den Polarisationsanalysator und das Projektionssystem (PS) gegangen ist.

2. Lithographisches Gerät gemäß Anspruch 1, wobei das Polarisationsänderungselement (10) verstellbar ist, indem es drehbar und/oder austauschbar ist.

**3.** Lithographisches Gerät gemäß Anspruch 1 oder 2, wobei das Polarisationsänderungselement (10) eine ¼-Platte ist.

**4.** Lithographisches Gerät gemäß Anspruch 1 oder 2, wobei der Polarisationsanalysator (12) ein Linearpolarisator ist.

**5.** Lithographisches Gerät gemäß Anspruch 1 oder 2, wobei der Polarisationsanalysator ein polarisierender Strahlteiler ist, der eingerichtet ist, um zwei orthogonal linear polarisierte Strahlungskomponenten räumlich getrennt voneinander auszugeben.

**6.** Lithographisches Gerät gemäß Anspruch 5, wobei der Polarisationsanalysator (12) im Wesentlichen aus KDP besteht.

**7.** Ein Verfahren zum Bestimmen mindestens einer Polarisationseigenschaft eines lithographischen Geräts, das ein Projektionssystem (PS) aufweist, wobei das Verfahren Folgendes beinhaltet:

Verwenden eines Detektors (14), um Intensitätsmessungen für eine Vielzahl von unterschiedlichen Einstellungen eines Polarisationsänderungselements (10) des lithographischen Geräts vorzunehmen, wobei das Polarisationsänderungselement (10) ein Verzögerer ist und in dem Weg der Strahlung vor einem Polarisationsanalysator (12) positioniert ist, wobei das
Polarisationsänderungselement (10) und der Polarisationsanalysator (12) vor dem Projektionssystem (PS) positioniert sind; und
Bestimmen, aus den Intensitätsmessungen, von Informationen über einen Polarisationszustand der Strahlung, bevor sie auf das
Polarisationsänderungselement trifft; wobei
der Detektor nach dem Projektionssystem (PS) positioniert ist und
Intensitätsmessungen vornimmt, die gegenüber Polarisationsvariationen, welche von dem Projektionssystem (PS) verliehen werden, unempfindlich sind.


**Revendications**

**1.** Un appareil lithographique comprenant :

un système d'illumination (IL) configuré pour conditionner un faisceau de rayonnement ;
un support (NT) construit pour supporter un dispositif servant à conformer selon un motif, le dispositif servant à conformer selon un motif étant capable de conférer au faisceau de rayonnement un motif dans sa coupe transversale afin de former un faisceau de rayonnement à motif ;
une table porte-substrat (WT) construite pour porter un substrat ;
un système de projection (PS) configuré pour projeter le faisceau de rayonnement à motif sur une portion cible du substrat ;
un élément de changement de polarisation ajustable (10) ; et
un analyseur de polarisation (12) ;
l'élément de changement de polarisation étant un retardateur ;
l'élément de changement de polarisation et l'analyseur de polarisation étant arrangés dans la trajectoire du faisceau de rayonnement dans cet ordre suivant la direction de propagation du faisceau de rayonnement à un niveau auquel le dispositif servant à conformer selon un motif serait supporté par le support ; et
l'appareil comprenant en outre : un détecteur (14) destiné à mesurer l'intensité du rayonnement après qu'il a traversé l'élément de changement de polarisation ajustable, l'analyseur de polarisation, et le système de projection (PS).

**2.** Un appareil lithographique selon la revendication 1, dans lequel l'élément de changement de polarisation (10) est ajustable en ce qu'il peut être tourné et/ou échangé.

**3.** Un appareil lithographique selon la revendication 1 ou la revendication 2, dans lequel l'élément de changement de polarisation (10) est une lame quart d'onde.

**4.** Un appareil lithographique selon la revendication 1 ou la revendication 2, dans lequel l'analyseur de polarisation (12) est un polariseur linéaire.

5. Un appareil lithographique selon la revendication 1 ou la revendication 2, dans lequel l'analyseur de polarisation est un séparateur de faisceau polarisant arrangé pour sortir deux composantes de rayonnement polarisées linéairement de façon orthogonale, séparées spatialement l'une de l'autre.

6. Un appareil lithographique selon la revendication 5, dans lequel l'analyseur de polarisation (12) consiste essentiellement en KDP.

7. Un procédé pour déterminer au moins une propriété de polarisation d'un appareil lithographique ayant un système de projection (PS), le procédé comprenant :

   utiliser un détecteur (14) pour prendre des mesures d'intensité pour une pluralité de paramétrages différents d'un élément de changement de polarisation (10) de l'appareil lithographique, l'élément de changement de polarisation (10) étant un retardateur et positionné dans la trajectoire du rayonnement avant un analyseur de polarisation (12), l'élément de changement de polarisation (10) et l'analyseur de polarisation (12) étant positionnés avant le système de projection (PS) ; et
   déterminer, d'après les mesures d'intensité, des informations sur un état de polarisation du rayonnement avant qu'il rencontre l'élément de changement de polarisation ;
   le détecteur étant positionné après le système de projection (PS) et prenant des mesures d'intensité qui sont insensibles à des variations de polarisation conférées par le système de projection (PS).

# Fig.1.

Illuminator

Retarder  Polariser  Camera

# Fig.2.

Illuminator (pupil shape)

Reticle — R — RS

Reticle stage

Projection lens — PL

Wafer — WS

Wafer stage — c

# Fig.3.

Polarisation sensor

A. Illuminator polarisation sensor

B. Projection lens (PL) polarisation sensor

Active reticle tool

2. Passive reticle tool

Retarder

Wedged prisms

Cam reticle level

Cam wafer level

Same combinations as for active reticle

Birefringent prisms

One-pass system through PL

Double-pass system through PL

Triple-pass system through PL

EP 1 910 898 B1

Fig.4.

EP 1 910 898 B1

Fig.5(a).

FS    L    P    C

y
z
x

X or y
polarised light

R
Rotating retarder
around z

Fig.6.

FS    L    P    C

y
z
x

X or y
polarised light

2 wedged prisms. WP.
each with different
orientations of the principal
axes

EP 1 910 898 B1

# Fig.5b.

Fig.7.

Fig.8(a).

Fig.9(b).

Fig.9(b).

Fig.9(c).

Fig.8b.

# Fig.8c.

89

87

86

88

84

82

# Fig.9(d).

1 Randomly polarised

2 Y-polarised

3 Right circular-polarised
4 Left circular-polarised
5 x-polarised

EP 1 910 898 B1

# Fig.10.

Incident ray
(unpolarised)

Reflected ray
(polarised)

$\theta_B$

Refracted ray
(slightly polarised)

# Fig.11.

## Fig.12.

IL

10

12

PS

16

14

## Fig.13.

20

22

10

18

12

PS

24

14

Fig.14.

Fig.15.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1037117 A
- US 20040114150 A
- EP 1267212 A
- US 20020001088 A
- US 6650399 B2
- US 10935741 B

**Non-patent literature cited in the description**

- **M BORN ; E WOLF.** Principles of Optics. Cambridge University Press, 1999